# EUROPEAN PATENT APPLICATION

(11) **EP 4 546 970 A1**
(43) Date of publication of application: **30.04.2025**
(21) Application number: 24191796.2
(22) Date of filing: 30.07.2024
(51) Int. Cl.: H10B 41/10, H10B 41/27, H10B 41/50, H10B 43/10, H10B 43/27, H10B 43/50

(54) **SEMICONDUCTOR DEVICES AND DATA STORAGE SYSTEMS INCLUDING THE SAME**

(30) Priority: 26.10.2023 KR 20230144908
(71) Applicant: SAMSUNG ELECTRONICS CO., LTD., Yeongtong-gu Suwon-si, Gyeonggi-do 16677 (KR)
(72) Inventor: LIM, Geunwon, 16677 Suwon-si (KR); KWON, Youngho, 16677 Suwon-si (KR); KIM, Chungjin, 16677 Suwon-si (KR); LEE, Jungho, 16677 Suwon-si (KR); JUNG, Yunkyu, 16677 Suwon-si (KR)
(74) Representative: Marks & Clerk LLP

(57) **Abstract**

A semiconductor device may include a plate layer, gate electrodes spaced apart from each other in a first direction perpendicular to an upper surface of the plate layer on the plate layer, extending to different lengths in a second direction perpendicular to the first direction and forming step regions, channel structures penetrating through the gate electrodes, extending in the first direction, and each including a channel layer, isolation regions penetrating through the gate electrodes and extending in the first direction and the second direction, sacrificial insulating layers on the same levels as levels of the gate electrodes, respectively, a through-via penetrating through the sacrificial insulating layers and extending in the first direction, a dam structure surrounding the through-via, and a guard structure spaced apart from the dam structure horizontally and having a closed loop shape surrounding the dam structure on a plan view.

## Description

### BACKGROUND

Aspects of the present disclosure relate to semiconductor devices and to data storage systems including the same.

A semiconductor device able to store high-capacity data in a data storage system is increasingly desired. Accordingly, methods for increasing data storage capacity of semiconductor devices have been researched. For example, one suggested method for increasing data storage capacity of a semiconductor device is to arrange memory cells three-dimensionally, instead of twodimensionally.

### SUMMARY

Some embodiments of the present disclosure provide semiconductor devices having improved reliability.

Some embodiments of the present disclosure provide data storage systems including semiconductor devices having improved reliability.

According to some embodiments of the present disclosure, a semiconductor device may include a first semiconductor structure including a substrate, circuit devices on the substrate, and circuit interconnection lines on the circuit devices, and a second semiconductor structure on the first semiconductor structure and having a through-interconnection region, wherein the second semiconductor structure includes a plate layer, gate electrodes spaced apart from each other in a first direction perpendicular to an upper surface of the plate layer on the plate layer, the gate electrodes extending to different lengths in a second direction perpendicular to the first direction and forming step regions, interlayer insulating layers alternately stacked with the gate electrodes, channel structures extending through the gate electrodes, the channel structures extending in the first direction, and each including a channel layer, isolation regions extending through the gate electrodes, extending in the first and second directions, and spaced apart from each other in a third direction perpendicular to the first and second directions, sacrificial insulating layers alternately stacked with the interlayer insulating layers in the through-interconnection region, a through-via extending through the sacrificial insulating layers and the interlayer insulating layers in the through-interconnection region and extending into the first semiconductor structure in the first direction, a dam structure surrounding the through-via, extending through the interlayer insulating layers, extending in the first direction, and including the channel layer, and a guard structure spaced apart from the dam structure horizontally, surrounding the dam structure, extending through the interlayer insulating layers, and extending in the first direction, wherein the dam structure and the guard structure have different internal structures.

According to some embodiments of the present disclosure, a semiconductor device includes a plate layer, gate electrodes spaced apart from each other in a first direction perpendicular to an upper surface of the plate layer on the plate layer, extending to different lengths in a second direction that is perpendicular to the first direction, the gate electrodes forming step regions, channel structures extending through the gate electrodes, extending in the first direction, and each including a channel layer, isolation regions extending through the gate electrodes and extending in the first direction and the second direction, sacrificial insulating layers that are respectively in parallel with the gate electrodes, respectively, a through-via extending through the sacrificial insulating layers and extending in the first direction, a dam structure surrounding the through-via, and a guard structure spaced apart from the dam structure horizontally and having a closed loop shape surrounding the dam structure on a plan view.

According to some embodiments of the present disclosure, a data storage system includes a semiconductor storage device including a first semiconductor structure including circuit devices, a second semiconductor structure on a first side of the first semiconductor structure, and an input/output pad electrically connected to the circuit devices, and a controller electrically connected to the semiconductor storage device through the input/output pad and configured to control the semiconductor storage device, wherein the second semiconductor structure includes a plate layer, gate electrodes spaced apart from each other on the plate layer in the first direction perpendicular to an upper surface of the plate layer, the gate electrodes extending to different lengths in the second direction perpendicular to the first direction, and forming staircase regions, channel structures extending through the gate electrodes, extending in the first direction, and each including a channel layer, isolation regions extending through the gate electrodes and extending in the first direction and the second direction, sacrificial insulating layers respectively in parallel with the gate electrodes, a through-via extending through the sacrificial insulating layers and extending in the first direction, a dam structure surrounding the through-via, and a guard structure spaced apart from the dam structure horizontally and surrounding the dam structure, wherein each of the gate electrodes includes a first region on an outer side of the guard structure and a second region surrounded by the guard structure, and wherein the first region and the second region are electrically isolated from each other.

The interlayer insulating layers may be alternately stacked with the gate electrodes in the first direction. The channel layer of the dam structure may be separate and distinct from the channel layers of the channel structures. The guard structure may be spaced apart from the dam structure in the second direction and/or third direction. The inner surface of the guard surface may be in contact with one or more gate electrodes, and the outer surface of the guard surface may be in contact with one or more other gate electrodes. An upper end of the dam structure and/or an upper end of the dam structure may be an upper end in the Z-direction. However, such a reference to upper (or similarly to lower, left or right) should not be understood as imparting an orientation or configuration to the semiconductor device. An upper end of the dam structure and an upper end of the guard structure may be non-coplanar in the third direction (e.g., Y-direction). For the purposes of the subject disclosure, the term surrounds or surrounding is understood to mean completely enclosing or enveloping such that elements on side cannot contact elements on another side, but does not necessarily imply direct contact between surrounded features. For example, the guard structure may surround the dam structure such that elements, e.g., gate electrodes, one side of the guard structure do not contact elements on the other side of the guard structure proximate the dam structure.

At least some of the above and other features of the disclosure are set out in the claims.

### BRIEF DESCRIPTION OF DRAWINGS

The above and other aspects, features, and advantages of the present disclosure will be more clearly understood from the following detailed description, taken in combination with the accompanying drawings, in which:
FIG. 1 is a plan view illustrating a semiconductor device according to some embodiments of the present disclosure;
FIGS. 2A, 2B, and 2C are cross-sectional views illustrating a semiconductor device according to some embodiments of the present disclosure;
FIGS. 3A, 3B, and 3C are cross-sectional views illustrating a semiconductor device according to some embodiments of the present disclosure;
FIG. 4 is a cross-sectional view illustrating a semiconductor device according to some embodiments of the present disclosure;
FIGS. 5A and 5B are a plan view and a cross-sectional view illustrating a semiconductor device according to some embodiments of the present disclosure;
FIGS. 6A and 6B are plan views illustrating a semiconductor device according to some embodiments of the present disclosure;
FIGS. 7A, 7B, 8A, 8B, 9A, 9B, 10A, 10B, 11A, and 11B are cross-sectional views illustrating a method of manufacturing a semiconductor device according to some embodiments of the present disclosure;
FIG. 12 is a view illustrating a data storage system including a semiconductor device according to some embodiments of the present disclosure;
FIG. 13 is a perspective view illustrating a data storage system including a semiconductor device according to some embodiments of the present disclosure; and
FIG. 14 is a cross-sectional view illustrating a semiconductor package according to some embodiments of the present disclosure.

### DETAILED DESCRIPTION

Hereinafter, some embodiments of the present disclosure will be described as follows with reference to the accompanying drawings.

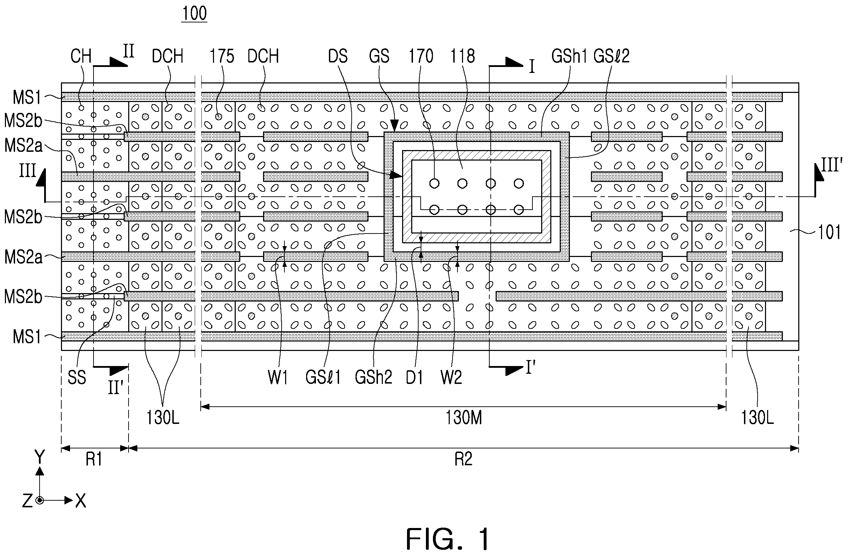

FIG. 1 is a plan view illustrating a semiconductor device according to some embodiments of the present disclosure.

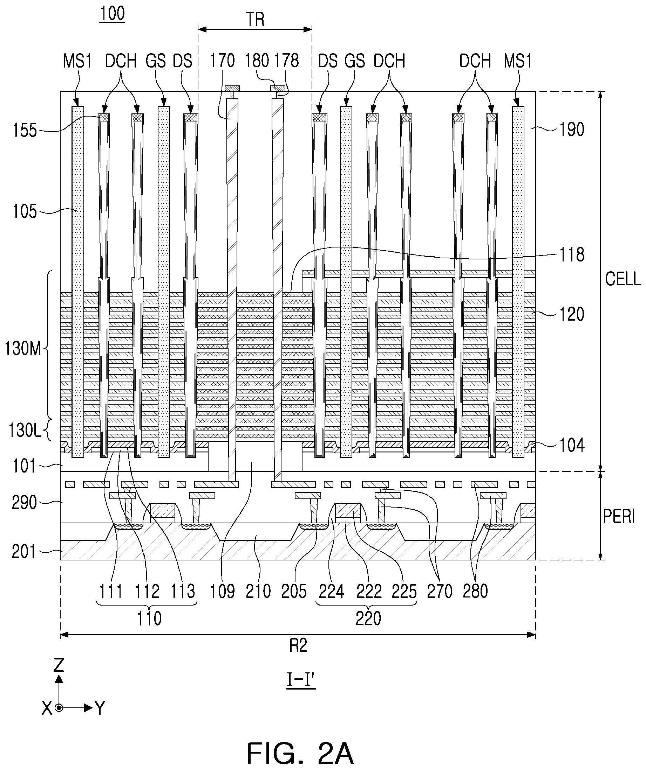

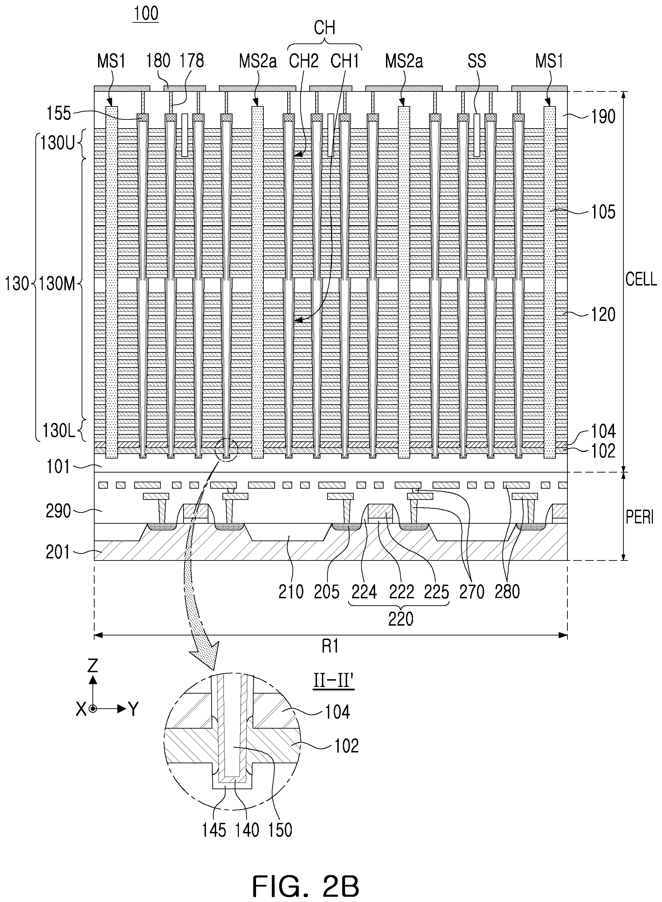

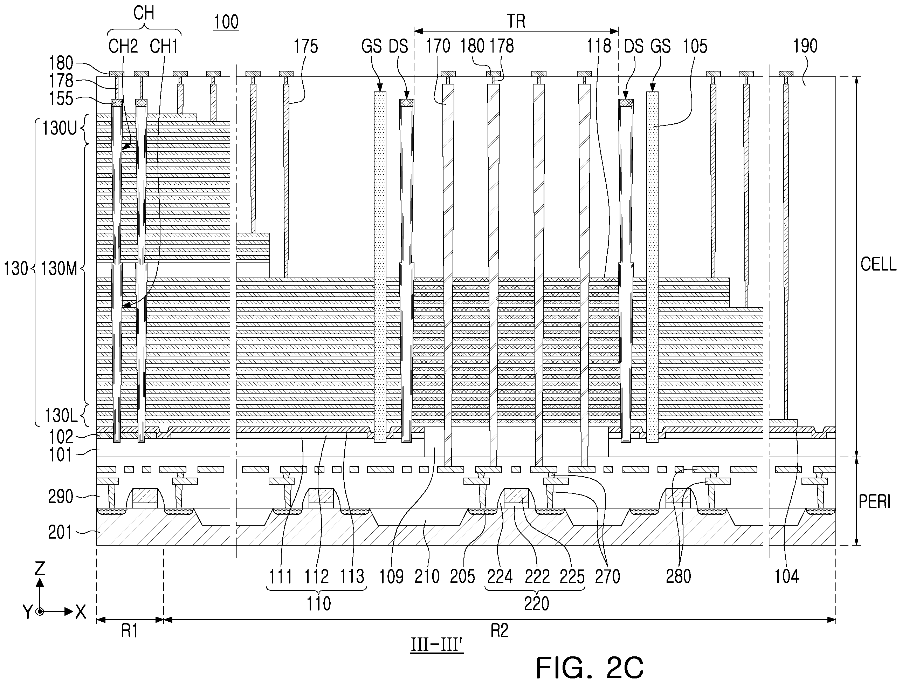

FIGS. 2A, 2B, and 2C are cross-sectional views illustrating a semiconductor device according to some embodiments of the present disclosure. FIG. 2A is a cross-sectional surface taken along line I-I' in FIG. 1, FIG. 2B is a cross-sectional surface taken along line II-II' in FIG. 1, and FIG. 2C is a cross-sectional surface taken along line III-III' in FIG. 1.

Referring to FIGS. 1, 2A, 2B, and 2C, the semiconductor device 100 may include a peripheral circuit region PERI, which may be a first semiconductor structure including a substrate 201, and a memory cell region CELL, which may be a second semiconductor structure including a plate layer 101. The memory cell region CELL may be on (e.g., above in a Z-direction) the peripheral circuit region PERI. In some embodiments, conversely, the memory cell region CELL may be below the peripheral circuit region PERI.

The peripheral circuit region PERI may include the substrate 201, impurity regions 205 and device isolation layers 210 in the substrate 201, circuit devices 220 on the substrate 201, a peripheral region insulating layer 290, circuit contact plugs 270, and circuit interconnection lines 280.

The substrate 201 may have an upper surface extending in an X-direction and a Y-direction. The X-direction, Y-direction, and Z-direction may be perpendicular to each other. An active region may be defined on the substrate 201 by the device isolation layers 210. The impurity regions 205 including impurities may be in a portion of the active region. The substrate 201 may include a semiconductor material, such as a group IV semiconductor, a group III-V compound semiconductor, or a group II-VI compound semiconductor. The substrate 201 may be provided as a bulk wafer or an epitaxial layer.

The circuit devices 220 may include planar transistors. Each of the circuit devices 220 may include a circuit gate dielectric layer 222, a spacer layer 224, and a circuit gate electrode 225. The impurity regions 205 may be source/drain regions in the substrate 201 on both sides of the circuit gate electrode 225.

The peripheral region insulating layer 290 may be on the circuit device 220 on the substrate 201. The peripheral region insulating layer 290 may include a plurality of insulating layers that may be formed in different manufacturing processes. The peripheral region insulating layer 290 may be formed of an insulating material.

The circuit contact plugs 270 and the circuit interconnection lines 280 may form a circuit interconnection structure that is electrically connected to the circuit devices 220 and the impurity regions 205. The circuit contact plugs 270 may have a cylindrical shape, and the circuit interconnection lines 280 may have a line shape. An electrical signal may be applied to the circuit device 220 through the circuit contact plugs 270 and the circuit interconnection lines 280. In regions not illustrated, the circuit contact plugs 270 may also be connected to the circuit gate electrode 225. The circuit interconnection lines 280 may be connected to the circuit contact plugs 270 and may be in a plurality of layers. The circuit contact plugs 270 and the circuit interconnection lines 280 a conductive material, for example, tungsten (W), copper (Cu), aluminum (Al), or the like, and each component may further include a diffusion barrier. In some embodiments, the number of layers of the circuit contact plugs 270 and the circuit interconnection lines 280 may be varied.

The memory cell region CELL may have first and second regions R1 and R2. The memory cell region CELL may include at least one of a plate layer 101, gate electrodes 130 stacked on the plate layer 101, channel structures CH that extend and penetrate through a stack structure of the gate electrodes 130 in the first region R1, first and second isolation regions MS1, MS2a, and MS2b, that extend and penetrate through the stack structure of the gate electrodes 130, sacrificial insulating layers 118 in the second region R2 that are in parallel with the gate electrodes 130 in, for example, the Y-direction, through-vias 170 penetrating through a stack structure of the sacrificial insulating layers 118 and extending in, for example, the Z-direction to the peripheral circuit region PERI and forming a through-interconnection region TR, a dam structure DS surrounding the through-vias 170, and a guard structure GS spaced apart from the dam structure DS and surrounding the dam structure DS.

The memory cell region CELL may include a first horizontal conductive layer 102 on the plate layer 101 in the first region R1, a horizontal insulating layer 110 in the second region R2 and arranged parallel to the first horizontal conductive layer 102 in, for example, the Y-direction, a second horizontal conductive layer 104 on the first horizontal conductive layer 102 and the horizontal insulating layer 110, a substrate insulating layer 109 that extends in, for example, the X-direction and penetrates the plate layer 101, interlayer insulating layers 120 alternately stacked with the gate electrodes 130, upper isolation regions SS that extend in, for example, the X-direction and penetrate a portion of the gate electrodes 130, dummy channel structures DCH that extend in, for example, Z-direction and penetrate through the stack structure of the gate electrodes 130 in the second region R2, gate contact plugs 175 connected to the gate electrodes 130, upper plugs 178, interconnection lines 180, and a cell region insulating layer 190.

In the memory cell region CELL, in the first region R1, the gate electrodes 130 may be vertically stacked in, for example, the Z-direction and the channel structures CH may be arranged to penetrate the gate electrodes 130, and memory cells may be provided in the first region R1, and in the second region R2, the gate electrodes 130 may extend in, for example, the X-direction to different lengths and the second region R2 and may electrically connect the memory cells to the peripheral circuit structure PERI. The second region R2 may be provided on at least one end of the first region R1 in at least one direction, for example, the X-direction.

The plate layer 101, the first horizontal conductive layer 102, and the second horizontal conductive layer 104 may form a source structure including a common source line of the semiconductor device 100. The plate layer 101 may have a shape of a plate and may function as at least a portion of a common source line. The plate layer 101 may have an upper surface that extends in the X-direction and the Y-direction. The plate layer 101 may include a conductive material. For example, the plate layer 101 may include a semiconductor material, such as a group IV semiconductor, a group III-V compound semiconductor, or a group II-VI compound semiconductor. For example, a group IV semiconductor may include silicon, germanium, or silicon-germanium. The plate layer 101 may further include impurities. For example, the plate layer 101 may be provided as a polycrystalline semiconductor layer, such as a polycrystalline silicon layer, or an epitaxial layer.

The first and second horizontal conductive layers 102 and 104 may be stacked in order on an upper surface of the plate layer 101 in the first region R1. The first horizontal conductive layer 102 may function as a portion of a common source line of the semiconductor device 100, for example, and may function as a common source line together with the plate layer 101. As illustrated in FIG. 2B, the first horizontal conductive layer 102 may be directly connected to the channel layer 140 around the channel layer 140 of each of the channel structures CH. The first horizontal conductive layer 102 may be in direct contact with the channel layer 140. The first horizontal conductive layer 102 may surround a portion of the channel layer 140. The first horizontal conductive layer 102 may surround a portion of the channel layer 140 in the Y-direction.

The second horizontal conductive layer 104 may be in contact with the plate layer 101 in some regions in which the first horizontal conductive layer 102 and the horizontal insulating layer 110 are not provided. The second horizontal conductive layer 104 may cover an end of the first horizontal conductive layer 102 or the horizontal insulating layer 110 in the regions described above, may be bent and may extend to the plate layer 101.

The first and second horizontal conductive layers 102 and 104 may include a semiconductor material, for example, polycrystalline silicon. In this case, at least the first horizontal conductive layer 102 may be a layer doped with impurities of the same conductivitytype as that of the plate layer 101.

The horizontal insulating layer 110 may be on the plate layer 101 and parallel in, for example, the X-direction with the first horizontal conductive layer 102 in at least a portion of the second region R2. The horizontal insulating layer 110 may include the first to third horizontal insulating layers 111, 112, and 113 stacked in, for example, the Z-direction, in order on the plate layer 101. The horizontal insulating layer 110 may be layers remaining after a portion is replaced with the first horizontal conductive layer 102 in a process of manufacturing the semiconductor device 100.

The horizontal insulating layer 110 may include silicon oxide, silicon nitride, silicon carbide, or silicon oxynitride. The first and third horizontal insulating layers 111, 113 and the second horizontal insulating layer 112 may include different insulating materials. The first and third horizontal insulating layers 111 and 113 may include the same material. For example, the first and third horizontal insulating layers 111 and 113 may be formed of the same material as that of the interlayer insulating layers 120, and the second horizontal insulating layer 112 may be formed of the same material as that of the sacrificial insulating layers 118.

The substrate insulating layer 109 may extend in, for example, the X-direction and may be in the plate layer 101, the horizontal insulating layer 110, and the second horizontal conductive layer 104 in a portion of the second region R2. An upper surface of the substrate insulating layer 109 may be coplanar with an upper surface of the second horizontal conductive layer 104 in, for example, the X-direction, but the present disclosure is not limited thereto. The substrate insulating layer 109 may include an insulating material, such as silicon oxide, silicon nitride, silicon carbide, or silicon oxynitride. In some embodiments, the substrate insulating layer 109 may be arranged as a plurality of layers to surround at least a portion of each of the through vias 170.

The gate electrodes 130 may be vertically spaced apart from each other on the plate layer 101, may be stacked, and may form a stack structure. The gate electrodes 130 may form a stack structure in the Z-direction. The gate electrodes 130 may include lower gate electrodes 130L forming a gate of a ground select transistor, memory gate electrodes 130M forming the plurality of memory cells, and upper gate electrodes 130U forming gates of the string select transistors. Depending on capacity of the semiconductor device 100, the number of the memory gate electrodes included in the memory cells may be determined. In some embodiments, the number of each of the upper and lower gate electrodes 130U and 130L may be 1 to 4 or more, and may have a structure the same as or different from that of the memory gate electrodes 130M. In some embodiments, the gate electrodes 130 may further include a gate electrode 130 provided on one side of upper gate electrodes 130U and/or the lower gate electrode 130L and forming an erase transistor used for an erase operation using gate induced drain leakage (GIDL) phenomenon. Also, a portion of the gate electrodes 130, for example, the memory gate electrodes 130M adjacent to the upper or lower gate electrodes 130U and 130L, may be dummy gate electrodes.

The gate electrodes 130 may be vertically stacked in, for example, the Z-direction and may be spaced apart from each other in the first region R1, may extend to different lengths in, for example, the X-direction from the first region R1 to the second region R2 and may form a step structure having a staircase shape. The gate electrodes 130 may form a step structure between the gate electrodes 130 in the X-direction, as illustrated in FIG. 2C. In some embodiments, at least a portion of the gate electrodes 130, for example, two to six gate electrodes 130, may form a gate group, and the gate groups may form a step structure in the X-direction. In this case, the gate electrodes 130 forming one of the gate groups may have a step structure in the Y-direction. By the step structure, the gate electrodes 130 may form a staircase shape in which a lower gate electrode 130 may extend longer in length in one or more horizontal directions than an upper gate electrode 130 above the lower gate electrode 130, and the staircase shape may provide ends exposed upwardly from the interlayer insulating layers 120. In some embodiments, the gate electrodes 130 may have an increased thickness on ends.

As illustrated in FIG. 1, the gate electrodes 130 may be isolated from each other in the Y-direction by the first isolation region MS 1 that extends in the X-direction. The gate electrodes 130 between a pair of first isolation regions MS1 may form a memory block, but embodiments of the memory block are not limited thereto. A portion of the gate electrodes 130, for example, the memory gate electrodes 130M, may form a layer in a memory block.

The gate electrodes 130 may include a metal material, such as tungsten (W). In example embodiments, the gate electrodes 130 may include polycrystalline silicon or metal silicide material. In some embodiments, the gate electrodes 130 may further include a diffusion barrier. For example, the diffusion barrier may include tungsten nitride (WN), tantalum nitride (TaN), titanium nitride (TiN), or a combination thereof.

The interlayer insulating layers 120 may be between the gate electrodes 130. Similarly to the gate electrodes 130, the interlayer insulating layers 120 may be spaced apart from each other in a direction perpendicular to an upper surface of the plate layer 101 (e.g., the Z-direction) and may extend in the X-direction. The interlayer insulating layers 120 may include an insulating material such as silicon oxide or silicon nitride.

The first and second isolation regions MS1, MS2a, and MS2b may penetrate through the gate electrodes 130 (e.g., in the Z-direction) and may extend in the X-direction. The first and second isolation regions MS1, MS2a, and MS2b may be parallel to each other (e.g., in the X-direction). The first and second isolation regions MS1, MS2a, and MS2b may penetrate through the entirety of the gate electrodes 130 stacked on the plate layer 101 (e.g., in the Z-direction) and may be connected to the plate layer 101. The first isolation regions MS 1 may extend as an integrated region along the X-direction, and the second isolation regions MS2a and MS2b may intermittently extend between a pair of first isolation regions MS1, or the second isolation regions MS2a and MS2b may be in only a portion of a region. For example, the second central isolation regions MS2a may extend as an integrated region from the first region R1 and may extend intermittently in the X-direction from the second region R2. The second auxiliary isolation regions MS2b may be only in the second region R2 and may extend intermittently in the X-direction. However, in some embodiments, the arrangement order and the number of the first and second isolation regions MS1, MS2a, and MS2b are not limited to the examples illustrated in FIG. 1. The first and second isolation regions MS1, MS2a, and MS2b may not overlap the through-interconnection region TR, and may be spaced apart from the through-interconnection region TR.

As illustrated in FIGS. 2A and 2B, a gate isolation insulating layer 105 may be in the first and second isolation regions MS1, MS2a, and MS2b. The gate isolation insulating layer 105 may have a shape of which a width may decrease toward the plate layer 101 due to a high aspect ratio thereof, but the present disclosure is not limited thereto. The gate isolation insulating layer 105 may include an insulating material, for example, silicon oxide, silicon nitride, or silicon oxynitride. In some embodiments, a conductive layer may be further provided in the gate isolation insulating layer 105 in the first and second isolation regions MS1, MS2a, and MS2b. In this case, the conductive layer may function as a common source line or a contact plug connected to a common source line of the semiconductor device 100.

The upper isolation regions SS may extend in the X-direction between the first isolation regions MS1 and the second central isolation region MS2a and between the second central isolation regions MS2a in the first region R1 as illustrated in FIG. 1. The upper isolation regions SS may penetrate a portion of the gate electrodes 130, including an uppermost upper gate electrode 130U among the gate electrodes 130 in, for example, the Z-direction. As illustrated in FIG. 2B, the upper isolation regions SS, for example, may isolate four gate electrodes 130, including upper gate electrodes 130U, from each other in the Y-direction. However, the number of gate electrodes 130 isolated by the upper isolation regions SS may be varied in different embodiments or implementations. The upper gate electrodes 130U isolated by a total of upper isolation regions SS may form different string selection lines. The upper isolation regions SS may include insulating material. The insulating material may include, for example, silicon oxide, silicon nitride, or silicon oxynitride.

The channel structures CH may extend or penetrate through the gate electrodes 130, may extend in the Z-direction and may be connected to the plate layer 101. Each of the channel structures CH may form a memory cell string, and the channel structures CH may be spaced apart from each other while forming rows and columns in the first region R1. The channel structures CH may form a grid pattern or in a zigzag pattern in one direction. The channel structures CH may have a pillar shape and, depending on the aspect ratio, the channel structures CH may have an inclined side surface having a width decreasing toward the plate layer 101 (e.g., in the Z-direction). The channel structures CH may include lower and upper channel structures CH1 and CH2 which may be vertically stacked (e.g., in the Z-direction). The channel structure CH may have a form in which the lower channel structure CH1 and the upper channel structure CH2 are connected to each other, and may have a bent portion due to a difference in width in the connection region.

As illustrated in the enlarged view in FIG. 2B, each of the channel structures CH may include a channel layer 140, a gate dielectric layer 145, a channel filling insulating layer 150, and a channel pad 155 in a channel hole. The channel hole may be formed through the gate electrodes 130, may extend in the Z-direction as will be described. The channel layer 140 may be formed in an annular shape surrounding an internal channel filling an insulating layer 150, but in some embodiments, the channel layer 140 may have a pillar shape such as a cylindrical shape or a prism shape and the channel filling insulating layer 150 may be absent or omitted. The channel layer 140 may be connected to the first horizontal conductive layer 102 in a lower portion. The channel layer 140 may include a semiconductor material such as polycrystalline silicon or single crystalline silicon.

The channel pads 155 may be on the channel layer 140 in the channel structures CH. The channel pads 155 may cover an upper surface of the channel filling insulating layer 150 and may be electrically connected to the channel layer 140. The channel pads 155 may include, for example, doped polycrystalline silicon.

The gate dielectric layer 145 may be between the gate electrodes 130 and the channel layer 140. Although not specifically illustrated, the gate dielectric layer 145 may include a tunneling layer, a charge storage layer, and a blocking layer stacked in order from the channel layer 140. The tunneling layer may tunnel electric charges into a charge storage layer, and may include, for example, silicon oxide (SiO₂), silicon nitride (Si₃N₄), silicon oxynitride (SiON), or a combination thereof. The charge storage layer may be a charge trap layer or a floating gate conductive layer. The blocking layer may include silicon oxide (SiO₂), silicon nitride (Si₃N₄), silicon oxynitride (SiON), a high-κ dielectric material, or a combination thereof. In some embodiments, at least a portion of the gate dielectric layer 145 may extend in a horizontal direction along the gate electrodes 130. In this case, the portion of the gate dielectric layer 145 may be referred to a portion of the gate electrode 130.

The dummy channel structures DCH may penetrate through the gate electrodes 130, may extend in the Z-direction and may be connected to the plate layer 101. The dummy channel structures DCH may have the same or similar internal structure as the channel structures CH, and may be substantially the same level as a level of the channel structures CH. However, the dummy channel structures DCH may not be electrically connected to the upper interconnection structures or may not form a memory cell string differently from the channel structures CH in the semiconductor device 100. In other words, the dummy channel structures DCH may be not be electrically connected to the plate layer 101. The dummy channel structures DCH may be spaced apart from each other in rows and columns in the second region R2. The dummy channel structures DCH may be in the first region R1 adjacent to the second region R2. The dummy channel structures DCH may be configured to support a stack structure of the interlayer insulating layers 120 during a process of manufacturing the semiconductor device 100.

As illustrated in FIG. 2A, the dummy channel structures DCH in the second region R2 may penetrate the horizontal insulating layer 110 in the Z-direction. A lower portion of the dummy channel structures DCH may be surrounded by a second horizontal conductive layer 104 and a horizontal insulating layer 110. Specifically, the dummy channel structures DCH may penetrate the interlayer insulating layers 120 and the gate electrodes 130 and may penetrate the second horizontal conductive layer 104 and the horizontal insulating layer 110 on a lower end. Each of the dummy channel structures DCH may include a channel layer 140, a gate dielectric layer 145, a channel filling insulating layer 150, and a channel pad 155 in the dummy channel hole, and may be similar in structure to the channel structures CH. Also, each of the dummy channel structures DCH may have a shape in which a lower dummy channel structure and an upper dummy channel structure are stacked similarly to the channel structure CH, and may have a bent portion accordingly.

The through-vias 170 may electrically connect the memory cell structure CELL and the peripheral circuit structure PERI to each other. The through-vias 170 may form a through-interconnection region TR together with sacrificial insulating layers 118, interlayer insulating layers 120, and a substrate insulating layer 109. In some embodiments, a region in the dam structure DS may be referred to as a through-interconnection region TR. Alternatively, the region in the guard structure GS may be referred to as the through-interconnection region TR.

For example, one through-interconnection region TR may be provided per memory block, and the through-interconnection region TR may be provided in the first region R1. In this case, in the first region R1, the sacrificial insulating layers 118 of the through-interconnection region TR may be on levels corresponding to the entire gate electrodes 130 (e.g., in parallel with the gate electrodes 130), and the dam structure DS and the guard structure GS that surround the through-interconnection region TR may be in contact with or adjacent to the sacrificial insulating layers 118. The number, the size, the arrangement type, and the shape of the through-interconnection region TR may be varied in different embodiments or implementations. For example, in some embodiments, the through-interconnection region TR may be disposed one per the plurality of memory blocks. The through-interconnection region TR may be spaced apart from the first and second isolation regions MS1, MS2a, and MS2b as illustrated in FIG. 1. For example, the through-interconnection region TR may be spaced apart from the first isolation regions MS1 adjacent each other in the Y-direction and may be disposed between a pair of the first isolation regions MS 1.

The through-vias 170 may extend vertically through a mold structure of the sacrificial insulating layers 118 and may extend into the peripheral circuit structure PERI. The through-vias 170 may electrically connect the gate electrodes 130 and/or the channel structures CH of the memory cell structure CELL to the circuit devices 220 of the peripheral circuit structure PERI. The through-vias 170 may be connected to the upper plugs 178 and the interconnection lines 180 in an upper portion. The through-vias 170 may be connected to the circuit interconnection lines 280 of the peripheral circuit structure PERI in a lower portion.

The through-vias 170 may penetrate the interlayer insulating layers 120 and the sacrificial insulating layers 118, and may penetrate the substrate insulating layer 109 in a lower portion. The number and the arrangement of through-vias 170 in a through-interconnection region TR may be varied in different embodiments and implementations. The through-vias 170 may include a conductive material, for example, tungsten (W), copper (Cu), aluminum (Al), or the like.

The sacrificial insulating layers 118 may on substantially the same level as (e.g., in parallel with) a level of the gate electrodes 130, respectively, in the through-interconnection region TR. The sacrificial insulating layers 118 may be alternately stacked with the interlayer insulating layers 120 in the through-interconnection region TR and may form a mold structure. The sacrificial insulating layers 118 may include an insulating material, for example, silicon oxide, silicon nitride, or silicon oxynitride. The sacrificial insulating layers 118 may be formed of a different material than that of the interlayer insulating layers 120. In the through-interconnection region TR, the sacrificial insulating layers 118 may have a width greater than that of the substrate insulating layer 109, but the present disclosure is not limited thereto, and the sacrificial insulating layers 118 may have the same width in different embodiments and implementations.

The dam structure DS may surround the through-interconnection region TR in the second region R2. As illustrated in FIG. 1, the through-interconnection region TR may be closer to one side with respect to a center in the Y-direction between adjacent first isolation regions MS1, and accordingly, the dam structure DS may also be closer to one of the first isolation regions MS 1. The dam structure DS may have a closed loop shape (e.g., a single closed loop shape) surrounding the through-vias 170 on a plan view, for example, a quadrangular ring, a circular ring, or an elliptical ring shape. The dam structure DS may include horizontal regions that extend in the X-direction and vertical regions that extend in the Y-direction on a plan view.

As illustrated in FIGS. 2A and 2C, the dam structure DS may extend or penetrate through the interlayer insulating layers 120, may extend in the Z-direction, may be connected to the plate layer 101, and may be on a boundary between the gate electrodes 130 and the sacrificial insulating layers 118. An external side surface of the dam structure DS may be in contact with the gate electrodes 130, and an internal side surface of the dam structure DS may be in contact with the sacrificial insulating layers 118. The dam structure DS may be on substantially the same level as (e.g., coplanar with) a level of the channel structures CH and the dummy channel structures DCH, which may be because the dam structure DS may be formed in a trench formed in the same process as a process of forming the channel structures CH and the dummy channel structures DCH. An upper surface of the dam structure DS may be coplanar with an upper surface of at least one of the channel structures CH and the dummy channel structure DCH. The dam structure DS may extend or penetrate through the second horizontal conductive layer 104 and the horizontal insulating layer 110, similarly to the arrangement of the dummy channel structures DCH in the second region R2.

The dam structure DS may have an internal structure the same as or similar to the dummy channel structures DCH and the channel structures CH. The dam structure DS may include a channel layer 140, a gate dielectric layer 145, a channel filling insulating layer 150, and a channel pad 155 in the trench, similarly to the channel structure CH. The dam structure DS may have a shape in which a lower dam structure and an upper dam structure are stacked similarly to the channel structure CH, and may have a bent portion accordingly.

The guard structure GS may be horizontally spaced (e.g., in the Y-direction) apart from the dam structure DS in the second region R2 and may surround the dam structure DS. On a plan view, the guard structure GS may have a closed loop shape (e.g., a single closed loop shape) similarly to the dam structure DS, and may have, for example, a quadrangular ring shape, a circular ring shape, or an oval ring shape. The guard structure GS may also be spaced apart from the first and second isolation regions MS1, MS2a, and MS2b. A spacing distance D1 between the guard structure GS and the dam structure DS may be varied in example embodiments.

On the plan view, the guard structure GS may include first and second horizontal regions GSh1 and GSh2 extending in the X-direction and first and second vertical regions GSl1 and GSl2 extending in the Y-direction. Each of the first and second horizontal regions GSh1 and GSh2 and the first and second vertical regions GSl1 and GSl2 may extend in the form of a line on a plan view. The first and second horizontal regions GSh1 and GSh2 may be in a linear line with the second isolation regions MS2a and MS2b, but the present disclosure is not limited thereto. A second width W2 of the first and second horizontal regions GSh1 and GSh2 may be substantially equal to a first width W1 of the first and second isolation regions MS 1, MS2a and MS2b. However, in some embodiments, the second width W2 may be smaller or larger than the first width W1. The second width W2 of the first and second horizontal regions GSh1 and GSh2 may be substantially the same as widths of the first and second vertical regions GSl1 and GSl2, but the present disclosure is not limited thereto.

As illustrated in FIGS. 2A and 2C, the guard structure GS may penetrate through the interlayer insulating layers 120 and the gate electrodes 130, may extend in the Z-direction and may be connected to the plate layer 101. Both an external side surface (i.e., outer surface) and an internal side surface of the guard structure GS may be in contact with the gate electrodes 130. The guard structure GS may isolate (e.g., completely isolate) regions of the gate electrodes 130 inside the guard structure GS from regions of the gate electrodes 130 on an external side of the guard structure GS on a plan view. The guard structure GS may isolate each of the gate electrodes 130 into two electrically isolated regions. The guard structure GS may be on substantially the same level as (e.g., coplanar with) a level of the first and second isolation regions MS1, MS2a, and MS2b, which may be because the guard structure GS is formed in a trench formed in the same process as a process of forming the first and second isolation regions MS1, MS2a, and MS2b. The guard structure GS may be in a region in which the second horizontal conductive layer 104 is in direct contact with the plate layer 101, similarly to the arrangement of the first and second isolation regions MS1, MS2a, and MS2b in the second region R2. Accordingly, the guard structure GS may extend or penetrate through the second horizontal conductive layer 104 in a lower portion, may be in contact with the horizontal conductive layer 104, and may be spaced apart from the first horizontal conductive layer 102 and the horizontal insulating layer 110. The guard structure GS may have a height different from that of the dam structure DS. The upper end of the guard structure GS may be on a level higher than a level of an upper end of the dam structure DS. The upper end of the guard structure GS may be non-coplanar with an upper end of the dam structure DS.

The guard structure GS may have an internal structure that is different from that of the dam structure DS. The guard structure GS may have an internal structure that is the same as or similar to that of the first and second isolation regions MS 1, MS2a, and MS2b. The guard structure GS may include a gate isolation insulating layer 105, which may be a single insulating layer in a trench, such as the first and second isolation regions MS1, MS2a, and MS2b. The guard structure GS may have a side surface which does not have a bent portion, differently from dam structure DS. However, in some embodiments, in the first and second isolation regions MS1, MS2a, and MS2b and the guard structure GS, the lower region and the upper region may be stacked and a bent portion may be formed therein, similarly to channel structures CH.

The semiconductor device 100 may include the dam structure DS, thereby preventing a material forming the gate electrodes 130 from flowing into the through-interconnection region TR during a manufacturing process, and controlling a region in which the gate electrodes 130 extend. However, as the dam structure DS is formed together with the channel structures CH, side surfaces may have unevenness, and mis-alignment may occur between the lower dam structure and the upper dam structure. In this case, defects such as the gate electrodes 130 being connected vertically may occur in a region adjacent to the dam structure DS. However, the semiconductor device 100 may further include the guard structure GS, such that the gate electrodes 130 inside the guard structure GS may be completely isolated from the gate electrodes 130 on an external side of the guard structure GS. Accordingly, even when a defect occurs in the gate electrodes 130 in the region adjacent to the dam structure DS, operation of the semiconductor device 100 may not be affected.

The gate contact plugs 175, the upper plugs 178, and the interconnection lines 180 may be part of an upper interconnection structure that is electrically connected to memory cells in the memory cell structure CELL.

As illustrated in FIG. 2C, the gate contact plugs 175 may be connected to the gate electrodes 130 of which an upper surface is exposed among the gate electrodes 130 in the second region R2. In some embodiments, the gate contact plugs 175 may extend or penetrate through the gate electrodes 130 and may extend into the peripheral circuit structure PERI. In this case, each of the gate contact plugs 175 may be connected to the uppermost gate electrode 130 and may be spaced apart from the gate electrodes 130 of a lower portion by another insulating layer. Upper plugs 178 may be connected to upper ends of the through-vias 170 and upper ends of the channel structures CH. The interconnection lines 180 may be electrically connected to, for example, the through-vias 170, the gate electrodes 130, and the channel structures CH. The number of the contact plugs and the interconnection lines included in the interconnection structure may be varied in different embodiments and implementations. Each of the gate contact plugs 175, the upper plugs 178, and the interconnection lines 180 may include a conductive material, for example, tungsten (W), copper (Cu), aluminum (Al), or the like

The cell region insulating layer 190 may cover the gate electrodes 130. The cell region insulating layer 190 may be formed of an insulating material and may be formed of a plurality of insulating layers.

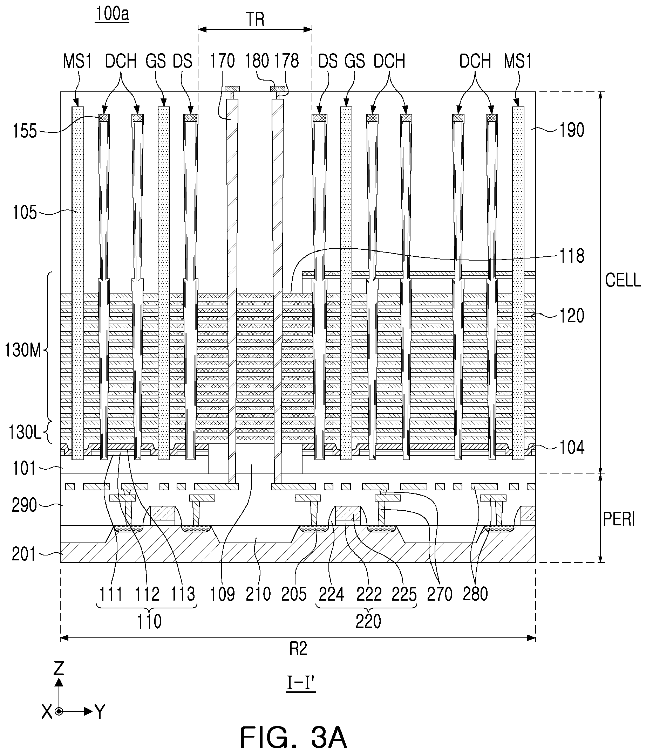

FIGS. 3A to 3C are cross-sectional views illustrating a semiconductor device according to some embodiments. FIGS. 3A to 3C illustrating a region corresponding to FIG. 2A.

Referring to FIG. 3A, in a semiconductor device 100a, the arrangement position of sacrificial insulating layers 118 adjacent to a through-interconnection region TR may be different from embodiments according to FIGS. 1 to 2C. Ends of the sacrificial insulating layers 118 in a horizontal direction may be between a dam structure DS and a guard structure GS. Accordingly, both an external side surface and an internal side surface of the dam structure DS may be in contact with the sacrificial insulating layers 118. Both an external side surface and an internal side surface of the guard structure GS may be in contact with gate electrodes 130.

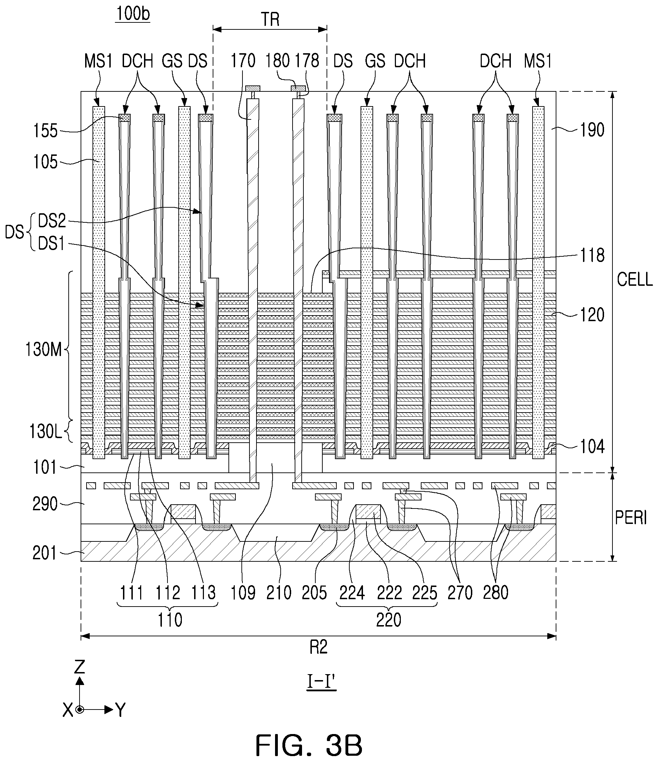

Referring to FIG. 3B, in a semiconductor device 100b, a lower dam structure DS1 and an upper dam structure DS2 of a dam structure DS may be misaligned with each other. The lower dam structure DS1 and the upper dam structure DS2 may be shifted from each other in the horizontal direction (e.g., in the Y-direction), and the shifted length may be varied in different embodiments and implementations. The upper dam structure DS2 may include a region connected to a side surface of the lower dam structure DS1. In this case, a lower end of upper dam structure DS2 may be on a level lower than a level of an upper end of the lower dam structure DS 1. However, in some embodiments, a lower end of the upper dam structure DS2 may be on the lower dam structure DS1. In some embodiments, the lower dam structure DS1 and the upper dam structure DS2 may not be connected to each other and may be completely shifted. In some embodiments, at least one of the dummy channel structures DCH may have a shape in which the lower region and the upper region are shifted from each other similarly to the dam structure DS.

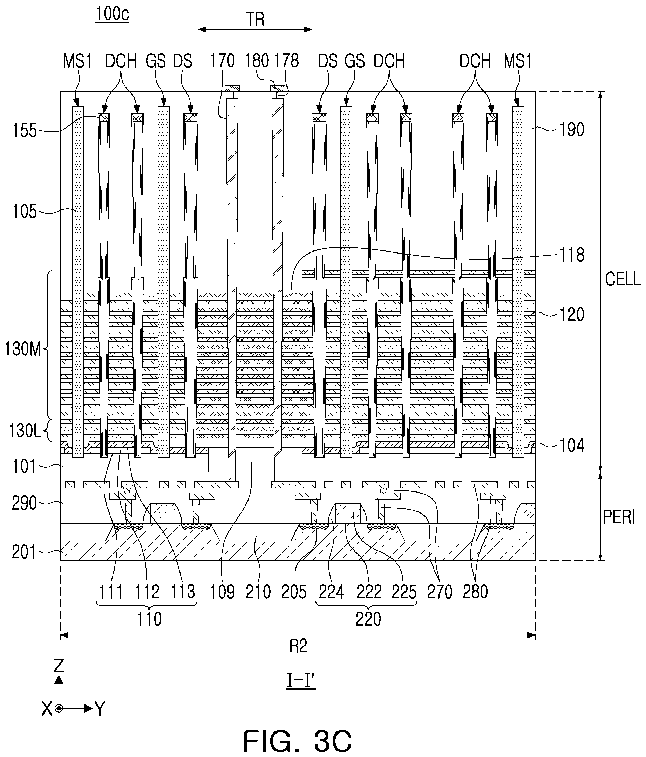

Referring to FIG. 3C, in a semiconductor device 100c, a horizontal insulating layer 110 may not be in a through-interconnection region TR. In the through-interconnection region TR, a second horizontal conductive layer 104 may be in direct contact with the plate layer 101. Accordingly, similarly to the arrangement of a guard structure GS, a dam structure DS may penetrate or extend through the second horizontal conductive layer 104 in a lower portion, may be in contact with the horizontal conductive layer 104, and may be spaced apart from the first horizontal conductive layer 102 and the horizontal insulating layer 110.

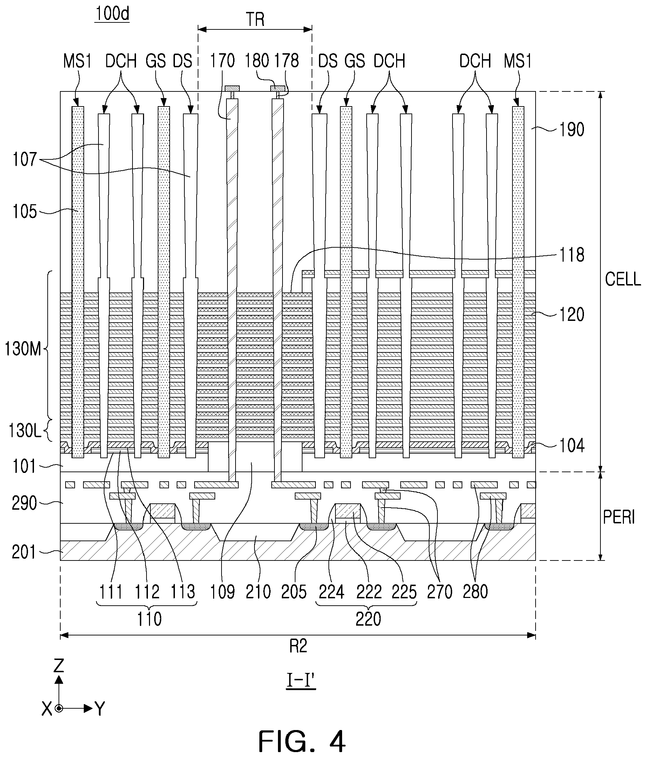

FIG. 4 is a cross-sectional view illustrating a semiconductor device according to some embodiments. FIG. 4 illustrates a region corresponding to FIG. 2A.

Referring to FIG. 4, in a semiconductor device 100d, an internal structure of a dummy channel structures DCH and a dam structure DS may be different from the embodiments according to FIGS. 1 to 2C. In some embodiments, the dummy channel structures DCH and the dam structure DS may have an internal structure different from channel structures CH. The dummy channel structures DCH and the dam structure DS may include a support insulating layer 107. The support insulating layer 107 may include a material the same as or different from that of the gate isolation insulating layer 105. The support insulating layer 107 may include an insulating material, for example, silicon oxide, silicon nitride, or silicon oxynitride. For example, the support insulating layer 107 may be a single insulating layer.

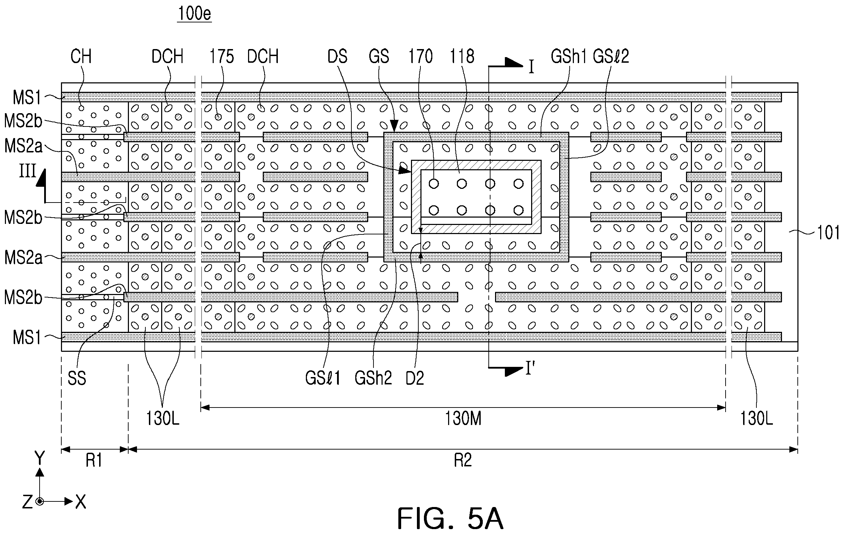

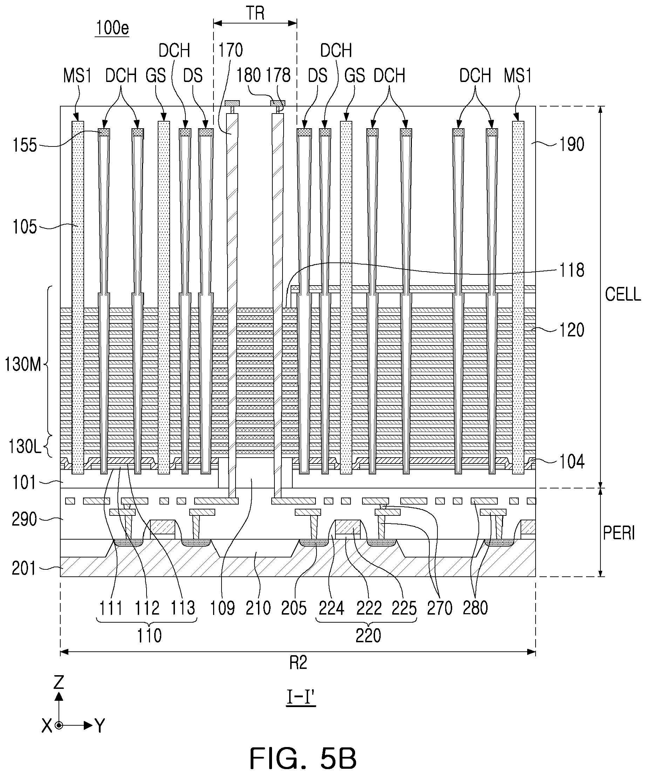

FIGS. 5A and 5B are a plan view and a cross-sectional view illustrating a semiconductor device according to some embodiments. FIG. 5A illustrates a region corresponding to FIG. 1. FIG. 5B illustrates a region corresponding to FIG. 2A.

Referring to FIGS. 5A and 5B, in a semiconductor device 100e, dummy channel structures DCH may be between a dam structure DS and a guard structure GS. When a distance D2 between the dam structure DS and the guard structure GS is relatively large, the dummy channel structures DCH may be in a region therebetween as seen in the figures, i.e., an interposed region. The dummy channel structures DCH may penetrate through the gate electrodes 130 in the interposed region. In FIGS. 5A and 5B, the dummy channel structures DCH may be in a row in the interposed region, but the number of dummy channel structures DCH in the interposed region and the arrangement thereof may be varied in example embodiments.

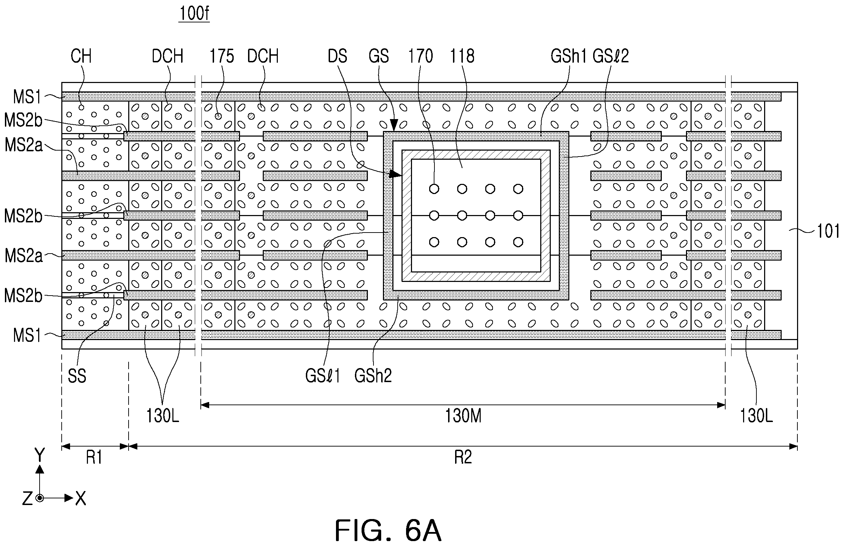

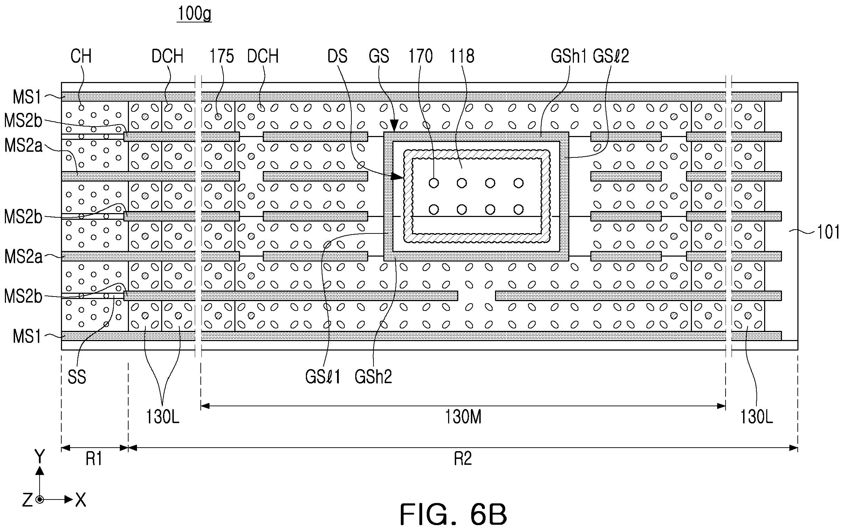

FIGS. 6A and 6B are plan views illustrating a semiconductor device according some embodiments. Each of FIGS. 6A and 6B illustrates a region corresponding to FIG. 1.

Referring to FIG. 6A, in a semiconductor device 100f, a dam structure DS and a guard structure GS may be in a symmetrical shape with respect to a center in the Y-direction between first isolation regions MS1 adjacent to each other. The first and second horizontal regions GSh1 and GSh2 may be colinear with first and second isolation regions MS1, MS2a, and MS2b. However, in some example embodiments, the first and second horizontal regions GSh1 and GSh2 may not be colinear or aligned with the first and second isolation regions MS1, MS2a, and MS2b. In some embodiments, the size and the shape of the dam structure DS and the guard structure GS may be varied in a range in which each of the dam structure DS and the guard structure GS forms a closed loop (e.g., a single closed loop).

Referring to FIG. 6B, in a semiconductor device 100g, the dam structure DS may have unevenness on side surfaces on a plan view. For example, the dam structure DS may have a shape in which circular patterns are connected to each other and may have unevenness accordingly. Since the semiconductor device 100g includes the guard structure GS, a degree of design freedom regarding a shape of the dam structure DS may be increased, and accordingly, the shape of the dam structure DS may be varied.

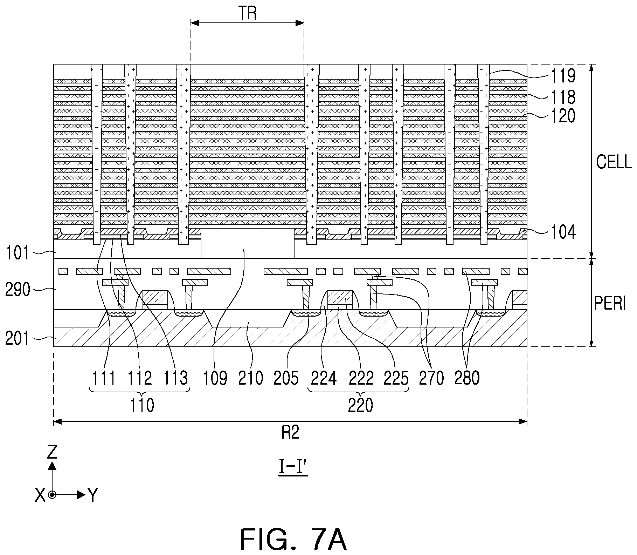

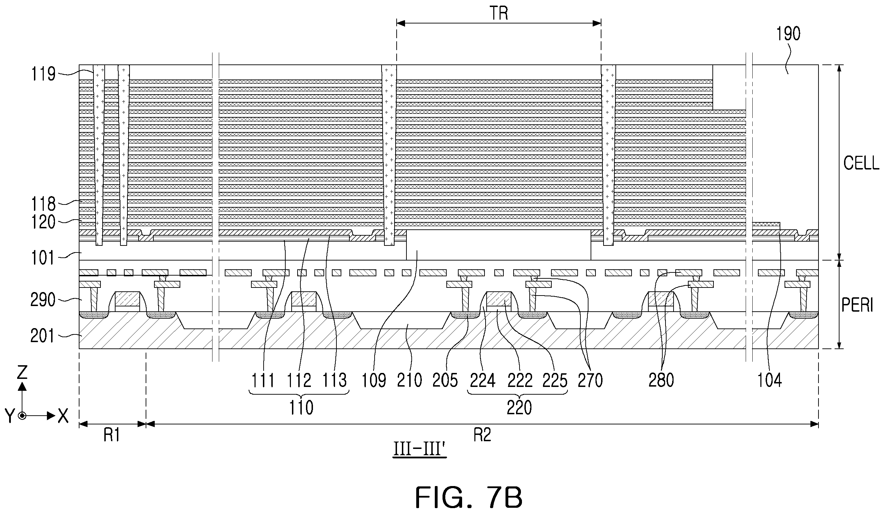

FIGS. 7A to 11B are cross-sectional views illustrating a method of manufacturing a semiconductor device according to some embodiments. Each of FIGS. 7A, 8A, 9A, 10A, and 11A illustrates a region corresponding to FIG. 2A, and each of FIGS. 7B, 8B, 9B, 10B, and 11B illustrates a region corresponding to FIG. 2C.

Referring to FIGS. 7A and 7B, a peripheral circuit structure PERI including circuit devices 220 and lower interconnection structures may be formed on a substrate 201, a plate layer 101, a horizontal insulating layer 110, a second horizontal conductive layer 104, and a substrate insulating layer 109 on which a memory cell structure CELL is provided may be formed on the peripheral circuit structure PERI, a lower mold structure may be formed by alternately stacking sacrificial insulating layers 118 and interlayer insulating layers 120, and lower vertical sacrificial layers 119 may be formed.

First, the device isolation layers 210 may be formed in the substrate 201, and the circuit gate dielectric layer 222 and the circuit gate electrode 225 may be sequentially formed on the substrate 201. The device isolation layers 210 may be formed, for example, by a shallow trench isolation (STI) process. The circuit gate dielectric layer 222 and the circuit gate electrode 225 may be formed using atomic layer deposition (ALD) or chemical vapor deposition (CVD). The circuit gate dielectric layer 222 may be formed of silicon oxide, and the circuit gate electrode 225 may be formed of at least one of polycrystalline silicon or a metal silicide layer, but the present disclosure is not limited thereto. Thereafter, a spacer layer 224 and impurity regions 205 may be formed on both sidewalls of the circuit gate dielectric layer 222 and the circuit gate electrode 225. In some embodiments, the spacer layer 224 may include a plurality of layers. Thereafter, impurity regions 205 may be formed by performing an ion implantation process.

Circuit contact plugs 270 of the lower interconnection structures may be formed by forming a portion of the peripheral region insulating layer 290, removing a portion by etching, and filling a conductive material therein. Circuit interconnection lines 280 may be formed by, for example, depositing a conductive material and patterning the material.

The peripheral region insulating layer 290 may include a plurality of insulating layers. A portion of the peripheral region insulating layer 290 may be formed in each of processes for forming the lower interconnection structures, and a portion thereof may be formed on the uppermost circuit interconnection line 280, such that the peripheral region insulating layer 290 may cover the circuit devices 220 and lower interconnection structures.

Thereafter, the plate layer 101 may be formed on the peripheral region insulating layer 290. The plate layer 101 may be formed of, for example, polycrystalline silicon and may be formed through a CVD process. The polycrystalline silicon forming the plate layer 101 may include impurities.

The first to third horizontal insulating layers 111, 112, and 113 forming horizontal insulating layer 110 may be stacked in order (e.g., sequentially) on the plate layer 101. A portion of the horizontal insulating layer 110 may be replaced with the first horizontal conductive layer 102 in FIGS. 2B and 2C through a subsequent process. The horizontal insulating layer 110 may be removed by a patterning process in a portion of regions.

The second horizontal conductive layer 104 may be formed on the horizontal insulating layer 110, and may be in contact with the plate layer 101 in a region from which the horizontal insulating layer 110 has been removed. Accordingly, the second horizontal conductive layer 104 may be bent along ends of the horizontal insulating layer 110, may cover the ends, and may extend to the plate layer 101. The second horizontal conductive layer 104 may be bent in the Z-direction along horizontal ends (i.e., in the Y-direction)

The substrate insulating layer 109 may be formed by removing a portion of the plate layer 101, the horizontal insulating layer 110, and the second horizontal conductive layer 104 in the through-interconnection region TR, and filling in an insulating material. The substrate insulating layer 109 may be formed throughout the entire region of the through-interconnection region TR, or may be formed in a region smaller than the entire region. After filling an insulating material, a planarization process may be further performed using a chemical mechanical polishing (CMP) process. Accordingly, an upper surface of the substrate insulating layer 109 may be substantially coplanar with an upper surface of the second horizontal conductive layer 104 in, for example, the Y-direction.

The lower mold structure may be formed on the second horizontal conductive layer 104 on a level on which the lower channel structures CH1 (see FIG. 2C) of the channel structures CH (see FIG. 2C) are provided.

A portion of the sacrificial insulating layers 118 may be replaced with the gate electrodes 130 (see FIG. 2A) through a subsequent process. The sacrificial insulating layers 118 may be formed of a material different from that of the interlayer insulating layers 120, and may be formed of a material etched with etch selectivity for the interlayer insulating layers 120 under specific etching conditions. For example, the interlayer insulating layer 120 may be formed of at least one of silicon oxide and silicon nitride, and the sacrificial insulating layers 118 may be formed of a material different from that of the interlayer insulating layer 120 selected from among silicon, silicon oxide, silicon carbide, and silicon nitride. In some embodiments, thicknesses of the interlayer insulating layers 120 may not be the same. For example, the interlayer insulating layer 120 forming an uppermost layer of the lower mold structure may have a relatively great thickness. The thickness of the interlayer insulating layers 120 and the sacrificial insulating layers 118 and the number of films included therein may be varied from the illustrated examples. Thereafter, in the second region R2, a portion of the lower mold structure may be removed such that the sacrificial insulating layers 118 may extend to different lengths and may form a staircase structure. In some example embodiments, the above process may be performed all at once after forming an upper mold structure described below. A cell region insulating layer 190 may be formed on the uppermost sacrificial insulating layers 118.

Lower vertical sacrificial layers 119 may be formed in a position corresponding to the lower channel structures CH1. The lower vertical sacrificial layers 119 may be further formed in regions corresponding to lower regions of the dummy channel structures DCH and a lower region of the dam structure DS in FIG. 2A. The lower vertical sacrificial layers 119 may be formed by forming holes and trenches to extend through the lower mold structure, filling a material forming the lower vertical sacrificial layers 119 and performing a planarization process. The lower vertical sacrificial layers 119 may include, for example, carbon (C), but the present disclosure is not limited thereto.

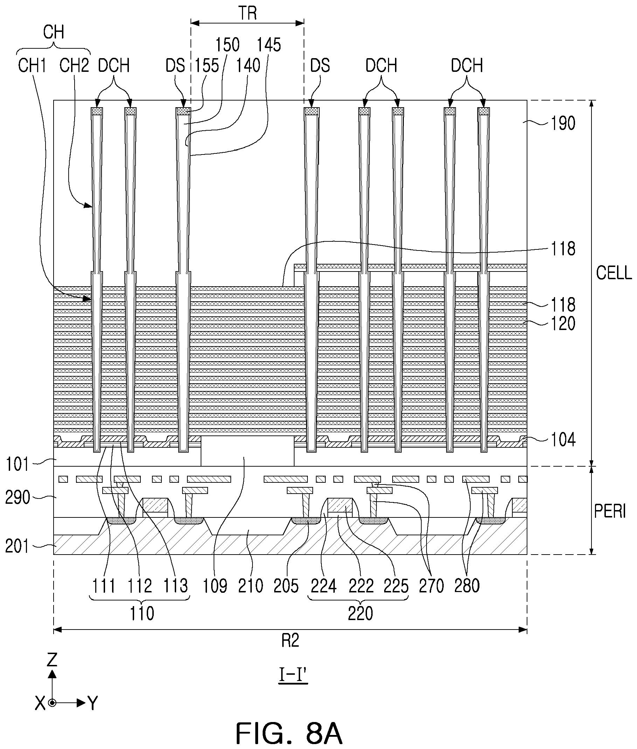

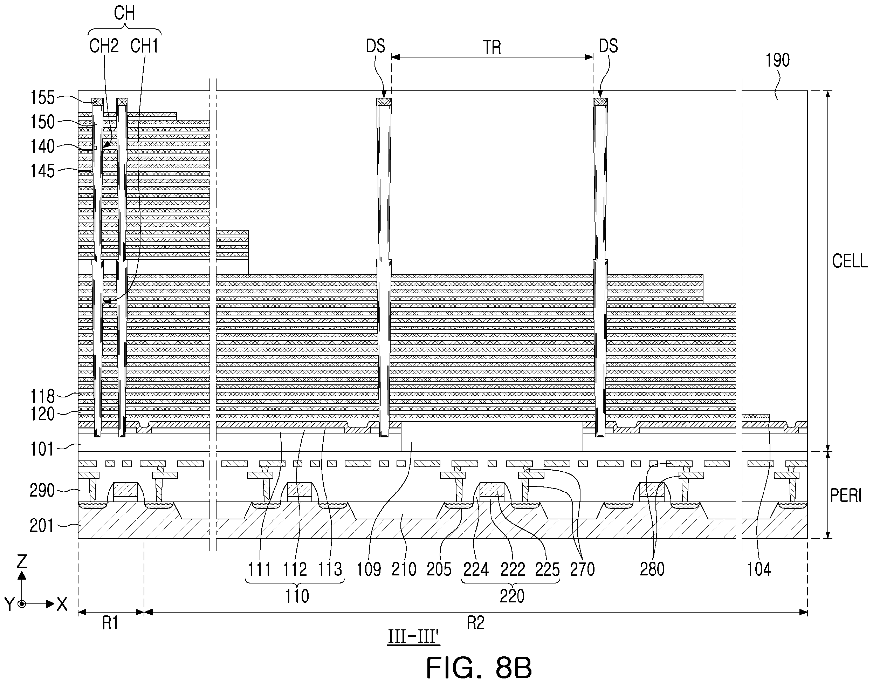

Referring to FIGS. 8A and 8B, an upper mold structure may be formed, and channel structures CH, dummy channel structures DCH, and dam structure DS may be formed.

The upper mold structure may be formed on a lower mold structure on a level on which the upper channel structures CH2 of the first channel structures CH (see FIG. 2C) are arranged. The upper mold structure may be formed by alternately stacking the sacrificial insulating layers 118 and the lower interlayer insulating layers 120 in the same manner as the lower mold structure. Thereafter, in the second region R2, a portion of the upper mold structure may be removed such that the sacrificial insulating layers 118 may extend to different lengths and may form a staircase structure. A cell region insulating layer 190 may be formed on the uppermost sacrificial insulating layers 118. Thereafter, upper vertical sacrificial layers connected to lower vertical sacrificial layers 119, respectively, may be formed.

Thereafter, channel holes, dummy channel holes, and dam structure trench may be formed by removing the lower vertical sacrificial layers 119 and the upper vertical sacrificial layers. For example, when the lower vertical sacrificial layers 119 and the upper vertical sacrificial layers include carbon (C), the lower vertical sacrificial layers 119 and the upper vertical sacrificial layers may be removed by an ashing process.

The channel structures CH, the dummy channel structures DCH, and the dam structure DS may be formed by depositing at least a portion of the gate dielectric layer 145, the channel layer 140, the channel filling insulating layer 150, and the channel pad 155 in the channel holes, the dummy channel holes, and the dam structure trench, respectively.

The gate dielectric layer 145 may be formed to have a relatively or substantially uniform thickness using an ALD or CVD process. In this process, the gate dielectric layer 145 may be formed partially or entirely, and a portion extending perpendicular to the plate layer 101 along the channel structures CH may be formed in this process. The channel layer 140 may be formed on the gate dielectric layer 145 in the channel holes, the dummy channel holes, and the dam structure trench. The channel filling insulating layer 150 may fill the channel holes, the dummy channel holes, and the dam structure trench, and may be an insulating material. Channel pad 155 may be formed after partially removing the channel filling insulating layer 150. The channel pad 155 may be formed of a conductive material, for example, polycrystalline silicon. Accordingly, the channel structures CH, the dummy channel structures DCH, and the dam structure DS formed as above may have the same internal structure. Thereafter, a cell region insulating layer 190 may be further formed.

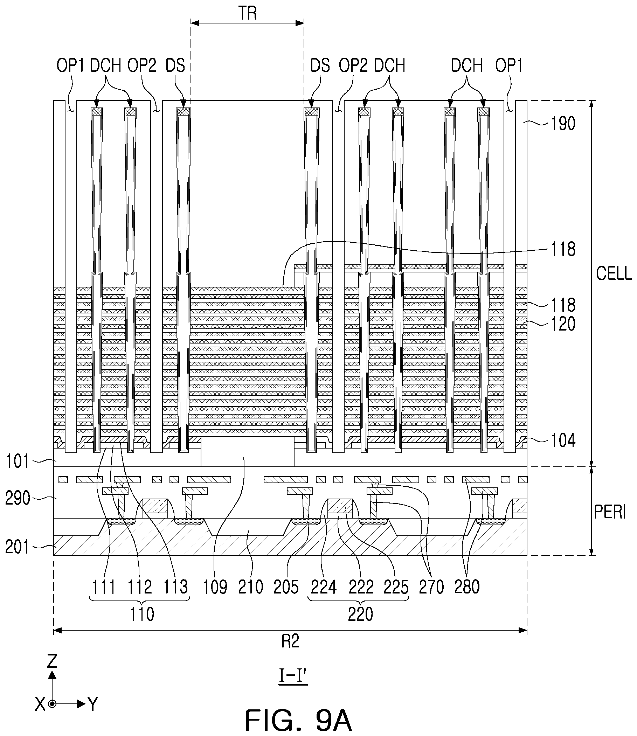

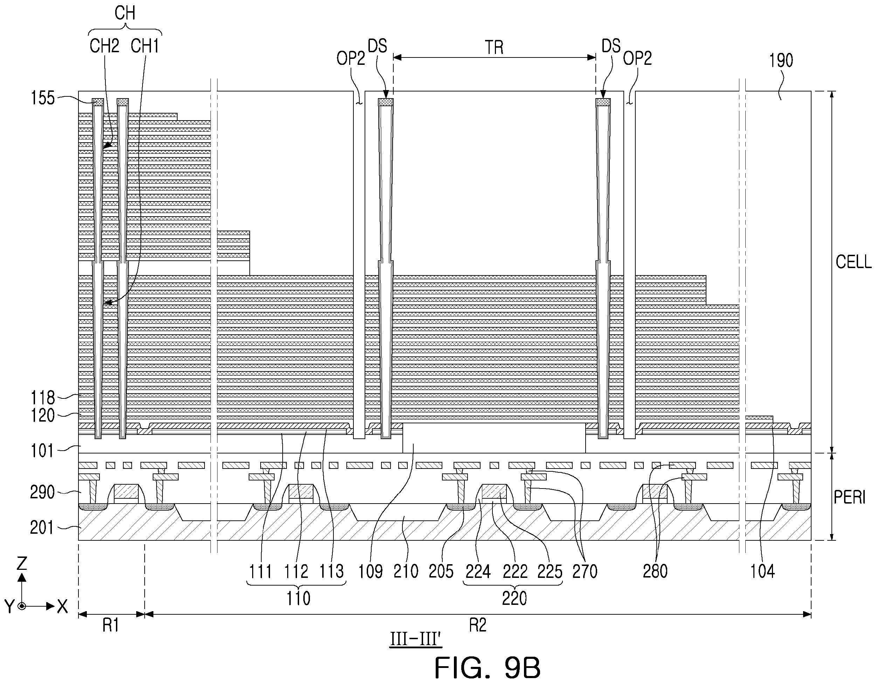

Referring to FIGS. 9A and 9B, first openings OP1 and second opening OP2 penetrating or extending through the mold structure of the sacrificial insulating layers 118 may be formed.

The first openings OP1 may be formed in regions corresponding to the first and second isolation regions MS1, MS2a, and MS2b (see FIG. 1), and the second opening OP2 may be formed in the region corresponding to the guard structure GS (see FIG. 2a). The first openings OP1 and the second opening OP2 may be formed by forming a mask layer using a photolithography process and anisotropically etching the mold structure. The first openings OP1 may be formed in a trench shape extending in the X-direction, and the second openings OP2 may be formed in a quadrangular ring shape or a shape similar thereto. The plate layer 101 may be exposed through bottom surfaces of the first openings OP1 and the second opening OP2.

In some embodiments, the lower vertical sacrificial layers 119 and the upper vertical sacrificial layers may be further formed in a position in which the first openings OP1 and the second opening OP2 are formed in the above-described processes. In this case, in this process, the first openings OP1 and the second opening OP2 may be formed by removing the lower vertical sacrificial layers 119 and the upper vertical sacrificial layers.

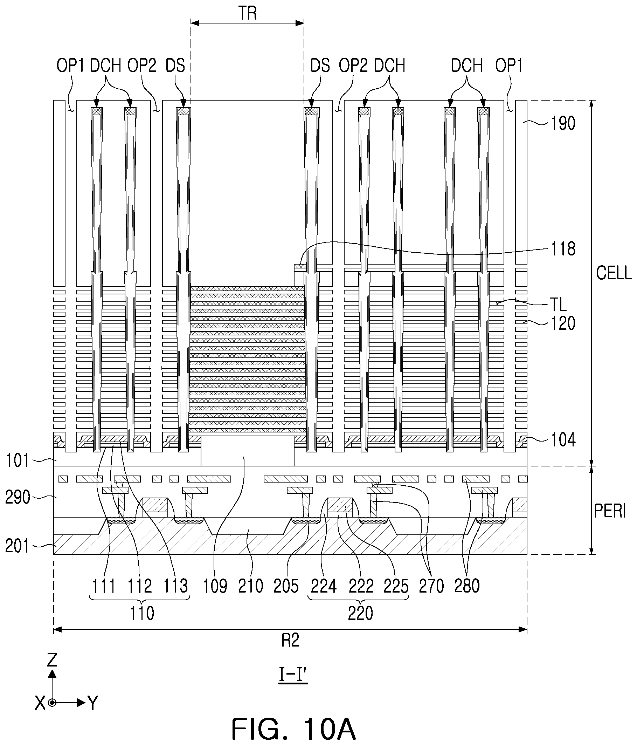

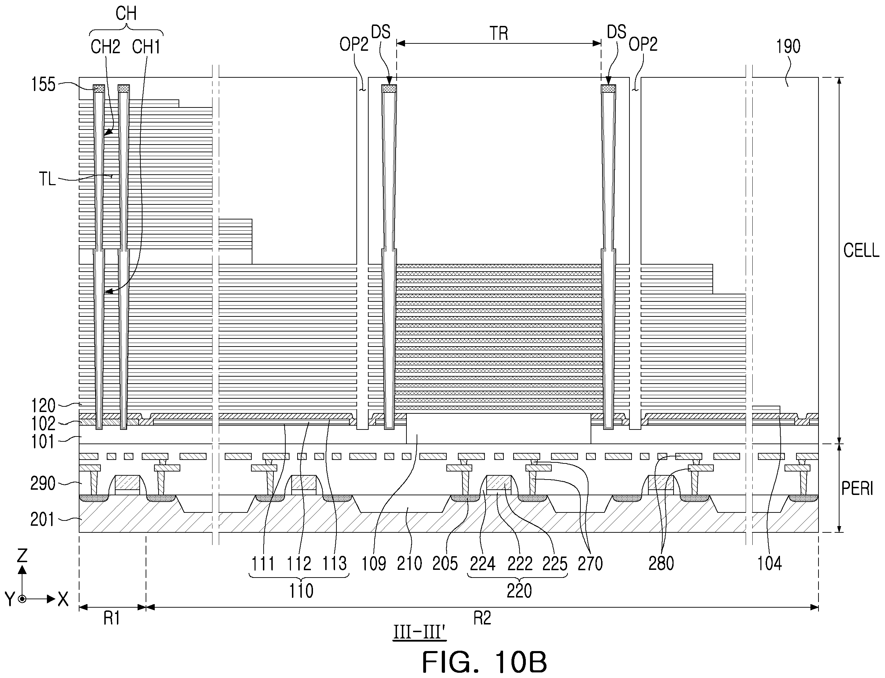

Referring to FIGS. 10A and 10B, after forming the first horizontal conductive layer 102, tunnel portions TL may be formed by removing a portion of the sacrificial insulating layers 118 through the first openings OP1 and the second opening OP2.

First, an etch-back process may be performed while forming sacrificial spacer layers in the first openings OP1 and the second opening OP2, thereby exposing the second horizontal insulating layer 112 in the first region R1. The second horizontal insulating layer 112 may be removed selectively from the exposed region, and the first and third horizontal insulating layers 111 and 113 thereabove and therebelow may be removed. The first to third horizontal insulating layers 111, 112, and 113 may be removed, for example, by a wet etching process. During the process of removing the first and third horizontal insulating layers 111 and 113, a portion of the gate dielectric layer 145 exposed in the region from which the second horizontal insulating layer 112 has been removed may also be removed. The first horizontal conductive layer 102 may be formed by depositing a conductive material in the region from which the first to third horizontal insulating layers 111, 112, and 113 have been removed, the sacrificial spacer layers may be removed. By this process, the first horizontal conductive layer 102 may be formed in the first region R1.

Thereafter, sacrificial insulating layers 118 may be removed from an external or outer side of the through-interconnection region TR. In the through-interconnection region TR, the sacrificial insulating layers 118 may remain and may form an insulating region of the through-interconnection region TR together with the interlayer insulating layers 120 and the substrate insulating layer 109. The sacrificial insulating layers 118 may be selectively removed with respect to the interlayer insulating layers 120, the second horizontal conductive layer 104, and the substrate insulating layer 109, for example, using wet etching. Accordingly, a plurality of tunnel portions TL may be formed between the interlayer insulating layers 120. A region in which the through-interconnection region TR is formed may be spaced apart from the first openings OP1 and the second opening OP2, and may be blocked by the dam structure DS, such that an etchant may not reach the region, and the sacrificial insulating layers 118 may remain.

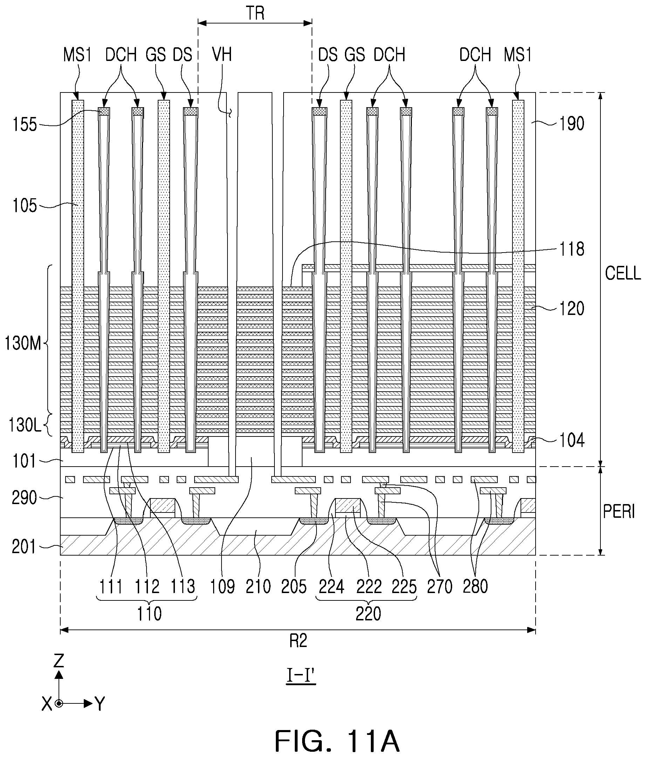

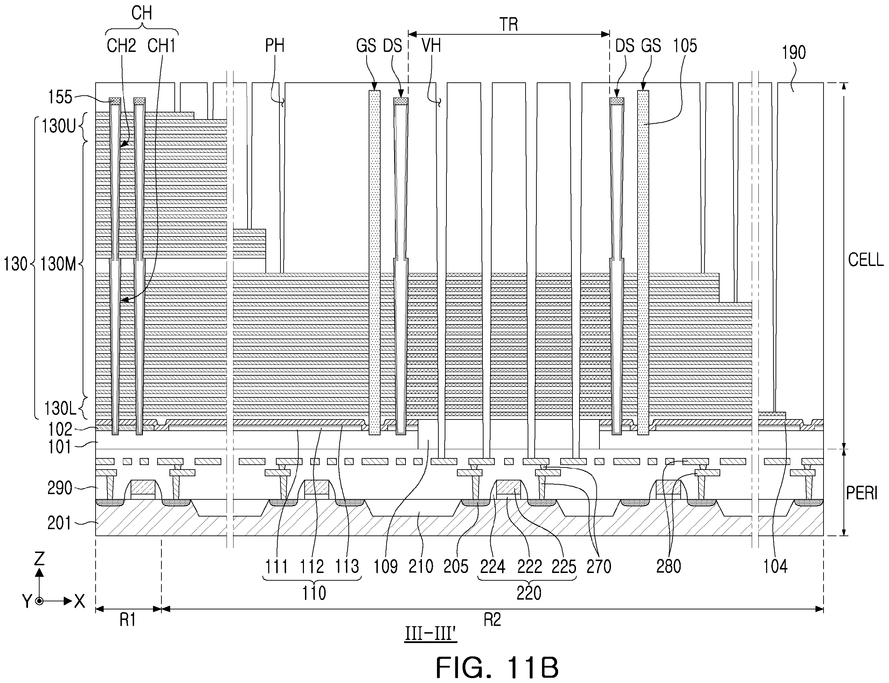

Referring to FIGS. 11A and 11B, gate electrodes 130 may be formed by filling the tunnel portions TL with a conductive material, first and second isolation regions MS1, MS2a, and MS2b and a guard structure GS may be formed, and via holes VH for forming the through-vias 170 (see FIG. 2A) may be formed in the through-interconnection region TR.

A conductive material forming the gate electrodes 130 may fill the tunnel portions TL. The conductive material may include a metal, polycrystalline silicon, or metal silicide material. A side surface of the gate electrodes 130 may be in contact with an outer side surface of the dam structure DS. The dam structure DS may prevent the conductive material from flowing into the through-interconnection region TR when the gate electrodes 130 is formed. After the gate electrodes 130 is formed, the conductive material deposited in the first openings OP1 and the second opening OP2 may be removed through an additional process. A gate isolation insulating layer 105 may fill the first openings OP1 and the second opening OP2. Accordingly, the first and second isolation regions MS1, MS2a, and MS2b and the guard structure GS may be formed. The first and second isolation regions MS1, MS2a, and MS2b and the guard structure GS may be formed together and have the same internal structure. Each of the gate electrodes 130 may be physically and electrically isolated into two regions by the guard structure GS.

Before forming via holes VH, a cell region insulating layer 190 may be formed to cover the gate isolation insulating layers 105. Thereafter, in the through-interconnection region TR, via holes VH penetrating the cell region insulating layer 190, the interlayer insulating layers 120, the sacrificial insulating layers 118, and the substrate insulating layer 109 may be formed. The circuit interconnection line 280 of the peripheral circuit structure PERI may be exposed on a lower end of the via holes VH. In this process, the contact holes PH may also be formed to form the gate contact plugs 175 (see FIG. 2C) connected to the gate electrodes 130.

Thereafter, referring to FIGS. 1 to 2C together, through-vias 170 and gate contact plugs 175 may be formed by filling the via holes VH and the contact holes PH with a conductive material, respectively. The upper plugs 178 may be formed on the through-vias 170 and the gate contact plugs 175, and interconnection lines 180 connected to upper ends of the upper plugs 178 may be formed, thereby manufacturing the semiconductor device 100.

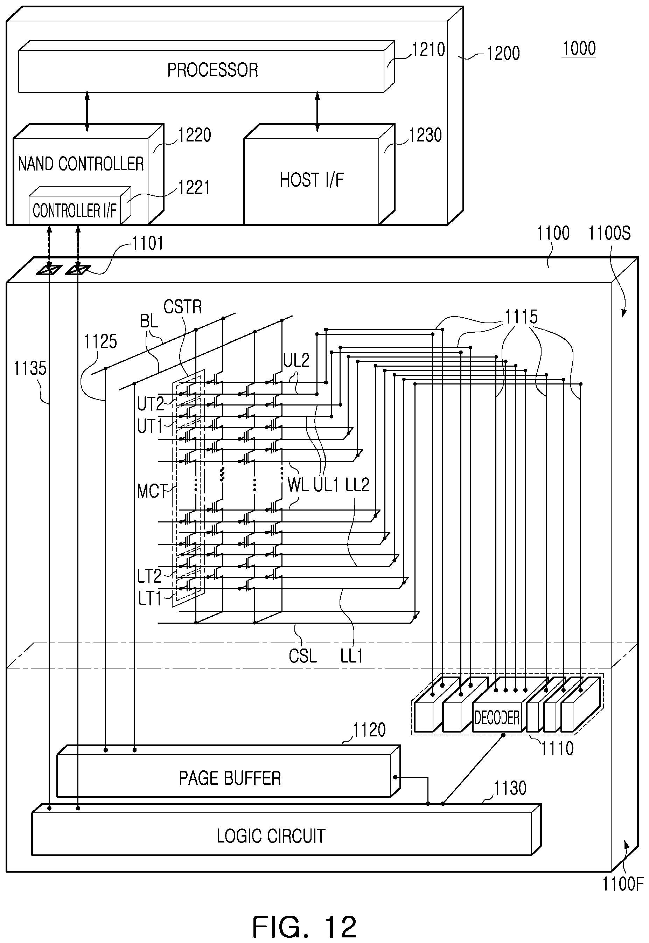

FIG. 12 is a view illustrating a data storage system including a semiconductor device according to some embodiments.

Referring to FIG. 12, a data storage system 1000 may include a semiconductor device 1100 and a controller 1200 electrically connected to the semiconductor device 1100. The data storage system 1000 may be implemented as a storage device including one or a plurality of semiconductor devices 1100 or an electronic device including a storage device. For example, the data storage system 1000 may be implemented as a solid state drive device (SSD) including one or a plurality of semiconductor devices 1100, a universal serial bus (USB), a computing system, a medical device, or a communication device.

The semiconductor device 1100 may be implemented as a non-volatile memory device, such as, for example, the NAND flash memory device described in the aforementioned embodiments with reference to FIGS. 1 to 6B. The semiconductor device 1100 may include a first structure 1100F and a second structure 11005 on the first structure 1100F. In some embodiments, the first structure 1100F may be on the side of the second structure 1100S. The first structure 1100F may be implemented as a peripheral circuit structure including a decoder circuit 1110, a page buffer 1120, and a logic circuit 1130. The second structure 11005 may be implemented as a memory cell structure including a bitline BL, a common source line CSL, wordlines WL, first and second gate upper lines UL1 and UL2, first and second gate lower lines LL1 and LL2 and memory cell strings CSTR disposed between the bitline BL and the common source line CSL.

In the second structure 1100S, each of the memory cell strings CSTR may include lower transistors LT1 and LT2 adjacent to the common source line CSL, upper transistors UT1 and UT2 adjacent to the bitline BL, and a plurality of memory cell transistors MCT between the lower transistors LT1 and LT2 and the upper transistors UT1 and UT2. The number of lower transistors LT1 and LT2 and the number of upper transistors UT1 and UT2 may be varied in different embodiments and implementations.

In some embodiments, the upper transistors UT1 and UT2 may include a string select transistor, and the lower transistors LT1 and LT2 may include a ground select transistor. The gate lower lines LL1 and LL2 may be configured as gate electrodes of the lower transistors LT1 and LT2, respectively. The wordlines WL may be configured as gate electrodes of the memory cell transistors MCT, and the gate upper lines UL1 and UL2 may be configured as gate electrodes of the upper transistors UT1 and UT2, respectively.

In some embodiments, the lower transistors LT1 and LT2 may include a lower erase control transistor LT1 and a ground select transistor LT2 connected to each other in series. The upper transistors UT1 and UT2 may include a string select transistor UT1 and an upper erase control transistor UT2 connected to each other in series. At least one of the lower erase control transistor LT1 and the upper erase control transistor UT2 may be used in an erase operation for erasing data stored in the memory cell transistors MCT using a GIDL phenomenon.

The common source line CSL, the first and second gate lower lines LL1 and LL2, the wordlines WL, and the first and second gate upper lines UL1 and UL2 may be electrically connected to the decoder circuit 1110 through first connection interconnections 1115 extending from the first structure 1100F to the second structure 11005. The bitlines BL may be electrically connected to the page buffer 1120 through second connection interconnections 1125 extending from the first structure 110F to the second structure 11005.

In the first structure 1100F, the decoder circuit 1110 and the page buffer 1120 may perform a control operation on at least one selected memory cell transistor among the plurality of memory cell transistors MCT. The decoder circuit 1110 and the page buffer 1120 may be controlled by the logic circuit 1130. The semiconductor device 1100 may communicate with the controller 1200 through the input/output pad 1101 electrically connected to the logic circuit 1130. The input/output pads 1101 may be electrically connected to the logic circuit 1130 through an input/output connection line 1135 extending from the first structure 1100F to the second structure 1100S.

The controller 1200 may include a processor 1210, a NAND controller 1220, and a host interface 1230. In some embodiments, the data storage system 1000 may include a plurality of semiconductor devices 1100, and in this case, the controller 1200 may control the plurality of semiconductor devices 1100.

The processor 1210 may control overall operation of the data storage system 1000 including the controller 1200. The processor 1210 may operate according to a predetermined firmware, and may access the semiconductor device 1100 by controlling the NAND controller 1220. The NAND controller 1220 may include a controller interface 1221 configured to process communication with the semiconductor device 1100. Through the controller interface 1221, a control command for controlling the semiconductor device 1100, data to be written to the memory cell transistors MCT of the semiconductor device 1100, and data to be read from the memory cell transistors MCT of the semiconductor device 1100 may be transmitted. The host interface 1230 may provide a communication function between the data storage system 1000 and an external host. When a control command from an external host is received through the host interface 1230, the processor 1210 may control the semiconductor device 1100 in response to the control command.

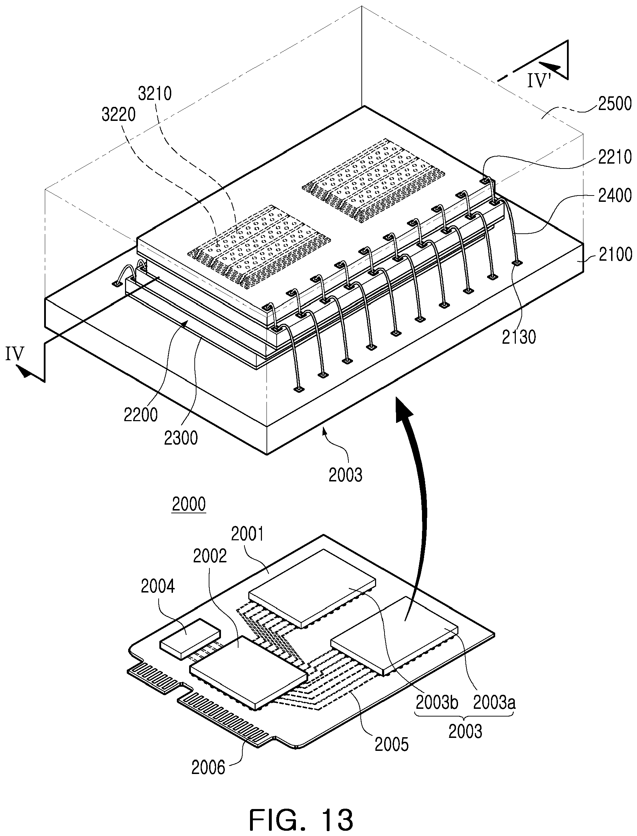

FIG. 13 is a perspective view illustrating a data storage system including a semiconductor device according to an example embodiment.

Referring to FIG. 13 a data storage system 2000 in some embodiments may include a main board 2001, a controller 2002 mounted on the main board 2001, one or more semiconductor packages 2003, and a DRAM 2004. The semiconductor package 2003 and the DRAM 2004 may be connected to the controller 2002 by interconnection patterns 2005 formed on the main board 2001.

The main board 2001 may include a connector 2006 including a plurality of pins coupled to an external host. The number and arrangement of the plurality of pins in the connector 2006 may vary depending on a communication interface between the data storage system 2000 and the external host. In some embodiments, the data storage system 2000 may communicate with an external host according to one of interfaces from among universal serial bus (USB), peripheral component interconnect express (PCI-Express), serial advanced technology attachment (SATA), M-Phy for universal flash storage (UFS). In some embodiments, the data storage system 2000 may operate by power supplied from an external host through the connector 2006. The data storage system 2000 may further include a power management integrated circuit (PMIC) for distributing power supplied from the external host to the controller 2002 and the semiconductor package 2003.

The controller 2002 may write data to or may read data from the semiconductor package 2003, and may improve an operating speed of the data storage system 2000.

The DRAM 2004 may be configured as a buffer memory for alleviating a difference in speeds between the semiconductor package 2003, which is a data storage space, and an external host. The DRAM 2004 included in the data storage system 2000 may operate as a cache memory, and may provide a space for temporarily storing data in a control operation for the semiconductor package 2003. When the data storage system 2000 may include the DRAM 2004, the controller 2002 may further include a DRAM controller for controlling the DRAM 2004 in addition to the NAND controller for controlling the semiconductor package 2003.

The semiconductor package 2003 may include first and second semiconductor packages 2003a and 2003b that are spaced apart from each other. Each of the first and second semiconductor packages 2003a and 2003b may be configured as a semiconductor package including a plurality of semiconductor chips 2200. Each of the first and second semiconductor packages 2003a and 2003b may include a package substrate 2100, semiconductor chips 2200 on the package substrate 2100, adhesive layers 2300 on lower surfaces of the semiconductor chips 2200, respectively, a connection structure 2400 electrically connecting the semiconductor chips 2200 to the package substrate 2100, and a molding layer 2500 that covers the semiconductor chips 2200 and the connection structure 2400 on the package substrate 2100.

The package substrate 2100 may be configured as a printed circuit board including package upper pads 2130. Each semiconductor chip 2200 may include an input/output pad 2210. The input/output pad 2210 may correspond to the input/output pad 1101 in FIG. 12. Each of the semiconductor chips 2200 may include gate stack structures 3210 and channel structures 3220. Each of the semiconductor chips 2200 may include the semiconductor device described in the aforementioned embodiments described with reference to FIGS. 1 to 6B.

In some embodiments, the connection structure 2400 may be configured as a bonding wire electrically connecting the input/output pad 2210 to the upper package pads 2130. Accordingly, in each of the first and second semiconductor packages 2003a and 2003b, the semiconductor chips 2200 may be electrically connected to each other by a bonding wire method, and may be electrically connected to the package upper pads 2130 of the package substrate 2100. In some embodiments, in each of the first and second semiconductor packages 2003a and 2003b, the semiconductor chips 2200 may be electrically connected to each other by a connection structure including a through-electrode (TSV) instead of the connection structure 2400 of a bonding wire method.

In some embodiments, the controller 2002 and the semiconductor chips 2200 may be included in a single package. In some embodiments, the controller 2002 and the semiconductor chips 2200 may be mounted on an interposer substrate different from the main board 2001, and the controller 2002 and the semiconductor chips 2200 may be connected to each other by interconnection formed on the interposer substrate.

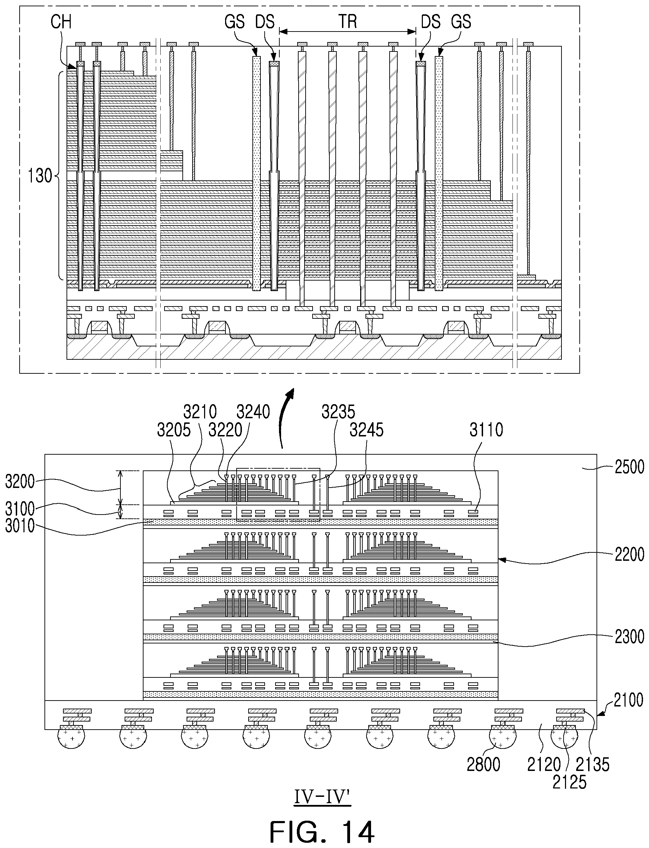

FIG. 14 is a cross-sectional view illustrating a semiconductor package according to some embodiments, illustrating an example embodiment of the semiconductor package 2003 in FIG. 13 taken along line IV-IV'.

Referring to FIG. 14, in the semiconductor package 2003, the package substrate 2100 may be implemented as a printed circuit substrate. The package substrate 2100 may include a package substrate body portion 2120, package upper pads 2130 on an upper surface of the package substrate body portion 2120, lower pads 2125 on the lower surface of the package substrate body 2120 or exposed through the lower surface, and internal interconnections 2135 electrically connecting the upper pads 2130 to the lower pads 2125 in the package substrate body 2120. The lower pads 2125 may be connected to the interconnection patterns 2005 of the main the substrate 2001 of the data storage system 2000 through the conductive connection portions 2800 as illustrated in FIG. 13.

Each of the semiconductor chips 2200 may include a semiconductor substrate 3010 and a first structure 3100 and a second structure 3200 stacked in order on the semiconductor substrate 3010. The first structure 3100 may include a peripheral circuit region including peripheral interconnections 3110. The second structure 3200 may include a common source line 3205, a gate stack structure 3210 on the common source line 3205, channel structures 3220 penetrating through the gate stack structure 3210, bitlines 3240 electrically connected to the channel structures 3220, and contact plugs 3235 electrically connected to the wordlines WL (see FIG. 12) of the gate stack structure 3210. As described in the aforementioned embodiments described with reference to FIGS. 1 to 6B, each of the semiconductor chips 2200 may include a dam structure DS and a guard structure GS surrounding the through-interconnection region TR in order.

Each of the semiconductor chips 2200 may include a through-interconnection 3245 electrically connected to the peripheral interconnections 3110 of the first structure 3100 and extending into the second structure 3200. The through-interconnection 3245 may be on an external side of the gate stack structure 3210 and may further be disposed to penetrate through the gate stack structure 3210. Each of the semiconductor chips 2200 may further include an input/output pad 2210 (see FIG. 13) electrically connected to the peripsumheral interconnections 3110 of the first structure 3100.

According to the inventive concepts presented herein, by including a dam structure and a guard structure surrounding the dam structure, a semiconductor device having improved reliability and a data storage system including the same may be provided.

While some examples of embodiments have been illustrated and described above, it will be apparent to those skilled in the art that modifications and variations can be made to the inventive concepts herein without departing from the scope of the present disclosure as defined by the appended claims.

Embodiments are set out in the following clauses:
Clause: 1 A semiconductor device, comprising:
   a first semiconductor structure including a substrate, circuit devices on the substrate, and circuit interconnection lines on the circuit devices; and
   a second semiconductor structure on the first semiconductor structure and having a through-interconnection region,
   wherein the second semiconductor structure includes:
      a plate layer;
      gate electrodes spaced apart from each other in a first direction perpendicular to an upper surface of the plate layer on the plate layer, the gate electrodes extending to different lengths in a second direction perpendicular to the first direction and forming step regions;
      interlayer insulating layers alternately stacked with the gate electrodes;
      channel structures extending through the gate electrodes, the channel structures extending in the first direction and each including a channel layer;
      isolation regions extending through the gate electrodes, extending in the first and second directions, and spaced apart from each other in a third direction perpendicular to the first and second directions;
      sacrificial insulating layers alternately stacked with the interlayer insulating layers in the through-interconnection region;
      a through-via extending through the sacrificial insulating layers and the interlayer insulating layers in the through-interconnection region and extending into the first semiconductor structure in the first direction;
      a dam structure surrounding the through-via, extending through the interlayer insulating layers, extending in the first direction, and including the channel layer; and
      a guard structure spaced apart from the dam structure horizontally, surrounding the dam structure, extending through the interlayer insulating layers, and extending in the first direction, and
      wherein the dam structure and the guard structure have different internal structures.
Clause 2: The semiconductor device of clause 1, wherein an outer surface and an inner surface of the guard structure are in contact with the gate electrodes.
Clause 3: The semiconductor device of clause 1 or 2, wherein an inner surface of the dam structure is in contact with the sacrificial insulating layers.
Clause 4: The semiconductor device of any preceding clause,
   wherein the dam structure and the channel structures have a same internal structure, and
   wherein the guard structure and the isolation regions have a same internal structure.
Clause 5: The semiconductor device of clause 4, wherein each of the channel structures and the dam structure includes a gate dielectric layer, the channel layer, and a channel filling insulating layer, arranged in sequence from the gate electrodes.
Clause 6: The semiconductor device of clause 4 or 5, wherein the guard structure includes a single insulating layer.
Clause 7: The semiconductor device of any preceding clause, wherein each of the guard structure and the dam structure has a closed loop shape.
Clause 8: The semiconductor device of any of clauses 1 to 6, wherein the guard structure has a quadrangular ring shape, a circular ring shape, or an elliptical ring shape when viewed in a plan view.
Clause 9: The semiconductor device of any preceding clause, wherein an upper end of the dam structure and an upper end of the guard structure are not coplanar.
Clause 10: The semiconductor device of any preceding clause, wherein the guard structure is spaced apart from the isolation regions.
Clause 11: The semiconductor device of any preceding clause,
   wherein the guard structure includes first regions that extend in the second direction and second regions that extend in the third direction, and
   wherein the first regions are arranged linearly with the isolation regions in the second direction.
Clause 12: The semiconductor device of any preceding clause,
   wherein the second semiconductor structure further includes dummy channel structures that extend in the first direction and penetrate at least a portion of the gate electrodes, and
   wherein at least one of the dummy channel structures is between the dam structure and the guard structure.
Clause 13: A data storage system, comprising:
   the semiconductor device of any one of the preceding clauses, the semiconductor device further including an input/output pad electrically connected to the circuit devices; and
   a controller electrically connected to the semiconductor device through the input/output pad and configured to control the semiconductor device.
Clause: 14 The data storage system of clause 13, wherein the guard structure has a closed loop shape on a plan view.

## Claims

1. A semiconductor device comprising:
a first semiconductor structure including a substrate, circuit devices on the substrate, and circuit interconnection lines on the circuit devices; and
a second semiconductor structure on the first semiconductor structure and having a through-interconnection region,
wherein the second semiconductor structure includes:
a plate layer;
gate electrodes spaced apart from each other in a first direction perpendicular to an upper surface of the plate layer on the plate layer, the gate electrodes extending to different lengths in a second direction perpendicular to the first direction and forming step regions;
interlayer insulating layers alternately stacked with the gate electrodes;
channel structures extending through the gate electrodes, the channel structures extending in the first direction and each including a channel layer;
isolation regions extending through the gate electrodes, extending in the first and second directions, and spaced apart from each other in a third direction perpendicular to the first and second directions;
sacrificial insulating layers alternately stacked with the interlayer insulating layers in the through-interconnection region;
a through-via extending through the sacrificial insulating layers and the interlayer insulating layers in the through-interconnection region and extending into the first semiconductor structure in the first direction;
a dam structure surrounding the through-via, extending through the interlayer insulating layers, extending in the first direction, and including the channel layer; and
a guard structure spaced apart from the dam structure , surrounding the dam structure, extending through the interlayer insulating layers, and extending in the first direction, and
wherein the dam structure and the guard structure have different internal structures.

2. The semiconductor device of claim 1, wherein an outer surface and an inner surface of the guard structure are in contact with the gate electrodes.

3. The semiconductor device of claim 1 or 2, wherein an inner surface of the dam structure is in contact with the sacrificial insulating layers.

4. The semiconductor device of any preceding claim,
wherein the dam structure and the channel structures have a same internal structure

5. The semiconductor device of any preceding claim,
wherein the guard structure and the isolation regions have a same internal structure.

6. The semiconductor device of claim 4, wherein each of the channel structures and the dam structure includes a gate dielectric layer, the channel layer, and a channel filling insulating layer, arranged in sequence from the gate electrodes.

7. The semiconductor device of claim 6, wherein the guard structure includes a single insulating layer.

8. The semiconductor device of any preceding claim, wherein at least one of the guard structure and the dam structure has a closed loop shape.

9. The semiconductor device of any of claims 1 to 7, wherein the guard structure has a quadrangular ring shape, a circular ring shape, or an elliptical ring shape when viewed in a plan view.

10. The semiconductor device of any preceding claim, wherein an upper end of the dam structure and an upper end of the guard structure are non-coplanar.

11. The semiconductor device of any preceding claim, wherein the guard structure is spaced apart from the isolation regions.

12. The semiconductor device of any preceding claim,
wherein the guard structure includes first regions that extend in the second direction and second regions that extend in the third direction, and
wherein the first regions are arranged linearly with the isolation regions in the second direction.

13. The semiconductor device of any preceding claim,
wherein the second semiconductor structure further includes dummy channel structures that extend in the first direction and penetrate at least a portion of the gate electrodes, and
wherein at least one of the dummy channel structures is between the dam structure and the guard structure.

14. A data storage system, comprising:
the semiconductor device of any one of the preceding claims, the semiconductor device further including an input/output pad electrically connected to the circuit devices; and
a controller electrically connected to the semiconductor device through the input/output pad and configured to control the semiconductor device.

15. The data storage system of claim 14, wherein the guard structure has a closed loop shape when viewed in a plan view.
